(19) Europäisches Patentamt
European Patent Office
Office européen des brevets

(11) EP 1 402 242 B1

(12) **EUROPEAN PATENT SPECIFICATION**

(45) Date of publication and mention of the grant of the patent:
**03.06.2009 Bulletin 2009/23**

(21) Application number: **02707668.6**

(22) Date of filing: **31.01.2002**

(51) Int Cl.:
***G01N 21/47*** *(2006.01)* ***H01L 21/66*** *(2006.01)*

(86) International application number:
**PCT/US2002/002990**

(87) International publication number:
**WO 2003/002990 (09.01.2003 Gazette 2003/02)**

# (54) USING SCATTEROMETRY TO DEVELOP REAL TIME ETCH IMAGE

VERWENDUNG VON STREULICHTMESSUNGEN ZUR ABBILDUNG DES ÄTZVORGANGES IN ECHTZEIT

UTILISATION DE LA DIFFUSOMETRIE DANS LE DEVELOPPEMENT D'UNE IMAGE DE GRAVURE EN TEMPS REEL

(84) Designated Contracting States:
**DE GB**

(30) Priority: **27.06.2001 US 893186**
**27.06.2001 US 893271**

(43) Date of publication of application:
**31.03.2004 Bulletin 2004/14**

(73) Proprietor: **ADVANCED MICRO DEVICES, INC.**
**Sunnyvale CA 94088-3453 (US)**

(72) Inventors:
- **SUBRAMANIAN, Ramkumar**
  **San Jose, CA 95129 (US)**
- **RANGARAJAN, Bharath**
  **Sunnyvale, CA 94086 (US)**
- **SINGH, Bhanwar**
  **Morgan Hill, CA 95037 (US)**
- **TEMPLETON, Michael, K. c/o IMT**
  **Goleta, CA 93117 (US)**

(74) Representative: **Picker, Madeline Margaret**
**Brookes Batchellor LLP,**
**102-108 Clerkenwell Road**
**London EC1M 5SA (GB)**

(56) References cited:
**EP-A- 0 841 692**
**WO-A-01/23871**
**US-A- 4 948 259**
**US-A- 5 719 495**
**US-A- 5 867 276**

EP 1 402 242 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

## TECHNICAL FIELD

The present invention generally relates to semiconductor processing, and in particular to a system and method for developing a real time etch image such as a dual damascene structure employing scatterometry analysis.

## BACKGROUND ART

WO-A-01/23871 discloses a method for characterising the quality of microelectronic features using broadband white light. The disclosed scatterometry technique is performed on etched wafers, and the results analysed and used for further processing of the wafer.

US-A-4 948 259 discloses a reflectometer to monitor a dry etching process performed on a transparent layer in real time.

In the semiconductor industry, there is a continuing trend toward higher device densities. The dimensions of and between such small features can be referred to as critical dimensions (CDs). Reducing CDs, and reproducing more accurate CDs facilitates achieving higher device densities.

The process of manufacturing semiconductors, or integrated circuits (commonly called ICs, or chips), typically consists of more than a hundred steps, during which hundreds of copies of an integrated circuit may be formed on a single wafer. Each step can affect the CDs of the ICs. Generally, the manufacturing process involves creating several patterned layers on and into the substrate that ultimately forms the complete integrated circuit. This layering process creates electrically active regions in and on the semiconductor wafer surface. One of the steps employed in manufacturing a semiconductor is an etch step, where selected portions of a layer (*e.g.*, unprotected oxide layer) are removed from a wafer. Such an etch step may comprise a multi-step process that may be performed many times during the fabrication of a semiconductor. Thus, the size, shape and isolation of the electrically active regions, and thus the reliability and performance of integrated circuits employing such regions depend, at least in part, on the precision with which etching can be performed.

Developing a precise etching process, where parameters including, but not limited to, chemical formulae, heat, time, pressure, light angles, and the like, are varied, can be a tedious, time and resource consuming undertaking, that may, ultimately, produce a process in which there is an incomplete understanding of the cause and effect relationships between certain etching process results and certain etching process parameters. Such uncertainty may arise due to the conventional method for characterizing an etch process. Conventionally, an etch process is characterized after the process is complete. Such characterization may include breaking open a wafer after it has been etched and examining results like profile, CDs, depths of trenches, height of features and so on. Based on the post etch examination, one or more etch parameters (*e.g.*, chemical formulae, heat, time, pressure, light angles) may be adjusted, and the etch/break/examine cycle repeated until an acceptable etch result is achieved.

Unfortunately, these types of end-point detection methods can be problematic for several reasons. For example, the effect of changing an etch parameter may not be discovered until the etch/break/examine cycle has been repeated numerous times. Furthermore, understanding the effect of changing etch parameters may require such parameters to be changed substantially in isolation, which can lengthen the etch process characterization procedure. In addition, post-fabrication detection/quality control data do not provide a user with real-time information related to the device being fabricated. Post-fabrication data may only allow an estimation or a projection as to what adjustments are needed to correct the fabrication errors and/or flaws. Such estimations and/or projections concerning necessary adjustments may lead to continued or recurring fabrication errors. Moreover, such a lengthy adjustment process may cause subsequent fabricated wafers to be wasted in the hopes of mitigating etch process errors.

Visual inspection methods employed in characterizing etch trim processes have been important in both production and development of integrated circuits. Visually inspecting etched wafers is well-known in the art. While visual inspection techniques may be simple to implement, they are difficult to automate. Further, visual techniques employing scanning electron microscopes (SEM) and atomic force microscopes (AFM) can be expensive, time-consuming and/or destructive.

Due to the extremely fine patterns that are exposed on the photo resist, controlling the etching process, whereby oxide and/or other conductive or insulating layers are removed, is a significant factor in achieving desired critical dimensions. Achieving greater precision in etch processes can result, for example, in achieving more precise CDs (e.g., desired lengths and widths between layers, between features and within features). Thus, an efficient system, and/or method, to more quickly and more accurately characterize etch processes is desired to facilitate manufacturing ICs exhibiting desired critical dimensions.

## DISCLOSURE OF THE INVENTION

A first aspect of the present invention provides a method for characterizing an etch process as defined by claim 1. The method includes logically partitioning a wafer into one or more portions. The method then establishes one or more gratings to be etched on the wafer, etches the wafer, and directs an incident light onto the gratings and collects light reflected from the grating. The reflected light is measured to determine one or more etching results associated with the grating (e. g., CDs, depth, profile). The method includes computing suggested adjustments for etching components by comparing scatterometry signatures associated with the measured etching results to scatterometry signatures associated with stored etching results and employing the signatures to compute the adjustments to the etch process.

A second aspect of the present invention provides a system for characterizing an etch process as defined by claim 4. The system includes an etching component that can etch at least one portion of a wafer and an etch component driving system for driving the etching component. The system includes a grating fabricating component operable to fabricate gratings on the wafer and a system for directing light toward gratings located on the wafer. The system further includes an etch monitoring system operable to measure etching results from light reflected from the gratings and a processor operatively coupled to the etch monitoring system and the etch component driving system. The processor receives etching result data from the measuring system and analyzes the etching result data by comparing the measured etching result data to stored etching result data to produce a real-time image of the etching results and, in one example, to compute suggested adaptations to the etch process being characterized.

An exemplary system can employ one or more light sources arranged to project light onto one or more features and/or gratings on a wafer, and one or more light sensing devices (e.g., photo detector, photodiode) for detecting light reflected and/or refracted by the one or more features and/or gratings as the features and/or gratings are being etched. Thus, the effects of changing one or more etch parameters (e.g., chemical formulae, heat, time, pressure, light angles) can be studied in-situ, with a resulting increase in the understanding of the cause/effect relationship between changing an etch parameter and the resulting etched wafer.

A grating is usually divided into a large number of sufficiently thin planar grating slabs to approximate an arbitrary profile. During etching, the light reflected from the one or more features and/or gratings is indicative of at least one parameter of etching processes (e.g., percent completion of etching) that can be measured to determine whether desired profiles, depths, critical dimensions (CDs), and so on are being achieved and to determine whether adaptations to the etching process being characterized should be undertaken.

One or more etching components can be arranged to correspond to a particular wafer portion. Alternatively, one or more etching components can be employed to etch various wafer portions. The etching components may be, for example, a gas plasma apparatus employed in reactive ion etching. It is to be appreciated that any suitable etching components may be employed with the present invention. For example, components including, but not limited to those employed in performing a main etch, a trim etch (e.g., etch step before main etch (e.g., descum etch), a PR trim and/or a BARC (breakthrough anti-reflective coating) etch) may be employed in accordance with the present invention. The etching components are selectively driven by the system to etch away oxide and/or other materials (e.g., in a polysilicon) at a desired location, at a desired rate, to a desired depth and/or to a desired width. The etching process is monitored by the system by comparing the etch results (e.g., CDs (space between features and/or gratings), depth, height, profiles) on the features and/or gratings on the wafer to desired results. Data gathered during such monitoring can be employed to gain an understanding of the results of changing one or more etch parameters (e.g., chemical formulae, heat, time, pressure, light angles). Similarly, data gathered during such monitoring can be analyzed to determine whether further adaptations to the etch process are desired. As a result, more optimal etching process characterization is achieved which can reduce the time and expense of producing an etch process that can subsequently be employed to produce high quality integrated circuits. Additionally, and/or alternatively, data concerning etch process conditions that resulted in favorable and/or unfavorable CDs can be stored to facilitate reproducing favorable etch process conditions for subsequent portions of the wafer being etched and/or for subsequent wafers.

## BRIEF DESCRIPTION OF THE DRAWINGS

Fig. 1 is a schematic block diagram of a system for characterizing an etch process in accordance with an aspect of the present invention.

Fig. 2 is a cross-sectional view of a wafer being etched and the etch process being characterized in accordance with an aspect of the present invention.

Fig. 3 is a cross-sectional view of a wafer and measurements taken in computing a real time image of the wafer during etching, in accordance with an aspect of the present invention.

Fig. 4 is a cross-sectional view of a wafer being etched and the etch process being characterized in accordance with an aspect of the present invention.

Fig. 5 is a front view of layers of oxide and resist deposited on a wafer;

Fig. 6 is a front view of a resist layer being exposed to a developing light and of non-developed portions of the resist layer removed.

Fig. 7 is a front view of an oxide layer with portions not protected by a developed resist etched away in accordance with an aspect of the present invention.

Fig. 8 illustrates a device with a multi-sloped profile that may be imaged in accordance with the present invention.

Fig. 9 illustrates a device with a multi-sloped profile that may be imaged in accordance with the present invention.

Fig. 10 is schematic block diagram of an etching process characterizing system in accordance with an aspect of the present invention.

Fig. 11 is a partial schematic block diagram of the system of Fig. 10 being employed in connection with characterizing an etching process by measuring etching results on a grating in accordance with an aspect of present invention.

Fig. 12 is a perspective illustration of a wafer that may be etched and monitored in accordance with an aspect of the present invention.

Fig. 13 is a representative three-dimensional grid map of a wafer illustrating etch result measurements taken in accordance with an aspect of the present invention.

Fig. 14 is an etching measurement table correlating the etch result measurements of Fig. 13 with stored etch measurement values in accordance with the present invention.

Fig. 15 illustrates an exemplary scatterometry system collecting reflected light.

Fig. 16 is a flow diagram illustrating one specific methodology for carrying out the present invention.

Fig. 17 is a simplified perspective view of an incident light reflecting off a surface, in accordance with an aspect of the present invention.

Fig. 18 is a simplified perspective view of an incident light reflecting off a surface, in accordance with an aspect of the present invention.

Fig. 19 illustrates a complex reflected and refracted light produced when an incident light is directed onto a surface, in accordance with an aspect of the present invention.

Fig. 20 illustrates a complex reflected and refracted light produced when an incident light is directed onto a surface, in accordance with an aspect of the present invention.

Fig. 21 illustrates a complex reflected and refracted light produced when an incident light is directed onto a surface, in accordance with an aspect of the present invention.

Fig. 22 illustrates phase and intensity signals recorded from a complex reflected and refracted light produced when an incident light is directed onto a surface, in accordance with an aspect of the present invention.

Fig. 23 is a cross-sectional view of CD measurements that may be monitored in accordance with an aspect of the present invention.

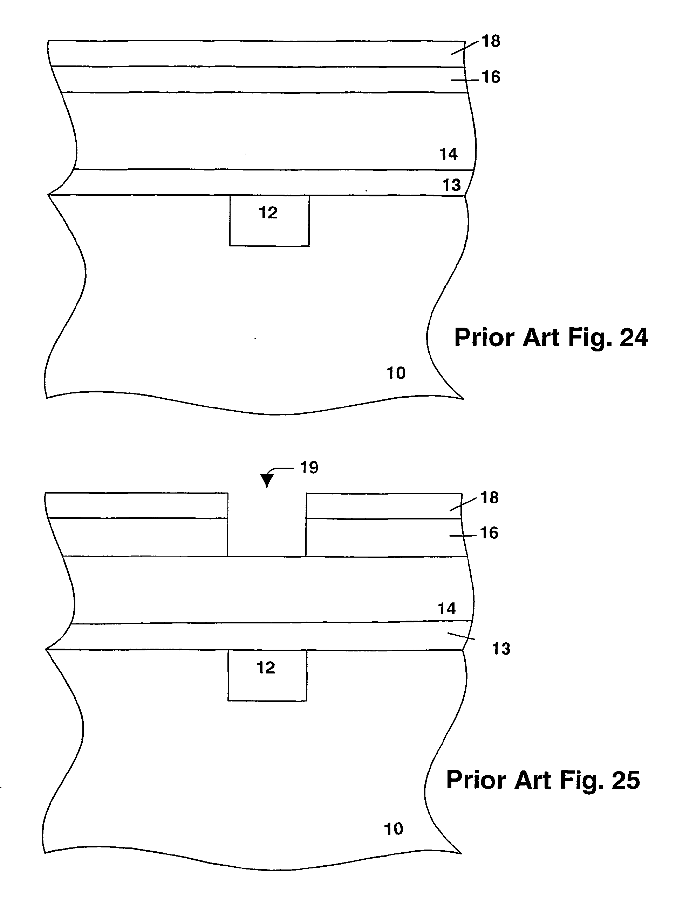

Prior Art Figure 24 illustrates a cross-sectional view of a semiconductor substrate having a low k material layer and a photoresist layer.

Figure Art Figure 25 illustrates a cross-sectional view of the semiconductor substrate of Prior Art Figure 24 after patterning of certain layers.

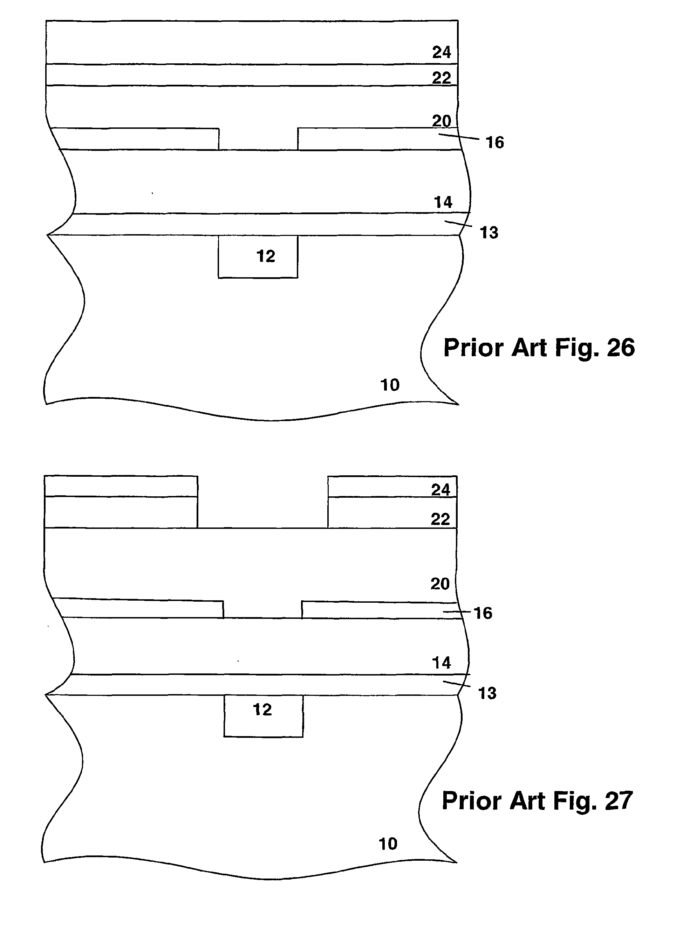

Prior Art Figure 26 illustrates a cross-sectional view of the semiconductor substrate of Prior Art Figure 25 after another low k material layer is formed.

Prior Art Figure 27 illustrates a cross-sectional view of the semiconductor substrate of Prior Art Figure 26 after patterning of certain layers.

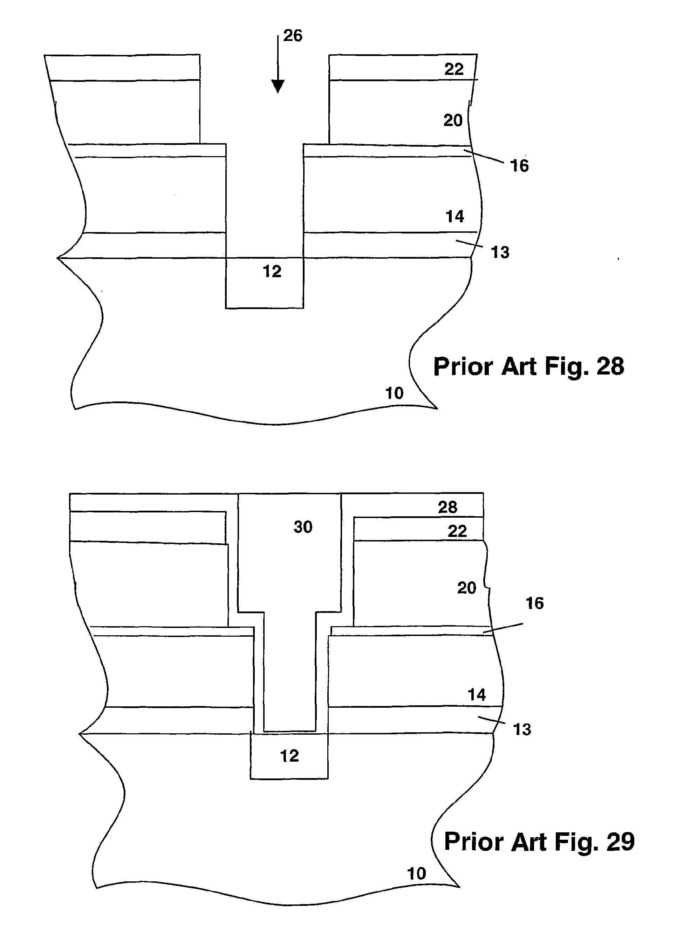

Prior Art Figure 28 illustrates a cross-sectional view of the semiconductor substrate of Prior Art Figure 27 after a portion of the low k material is removed.

Prior Art Figure 29 illustrates a cross-sectional view of the semiconductor substrate of Prior Art Figure 28 after a barrier layer and a conductive layer are formed.

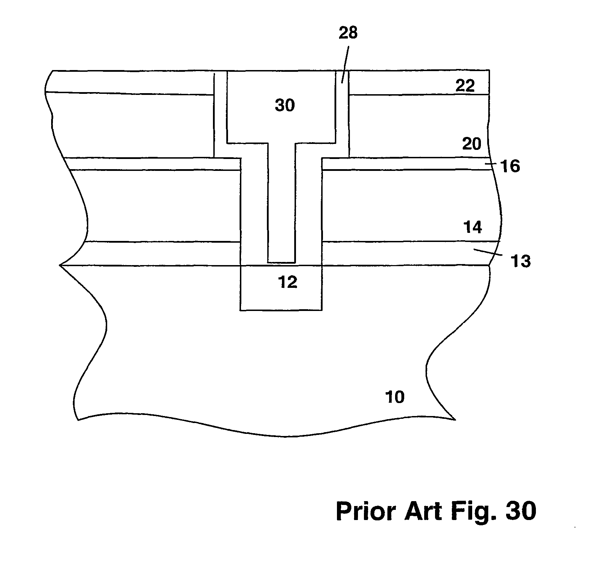

Prior Art Figure 30 illustrates a cross-sectional view of the semiconductor substrate of Prior Art Figure 29 after the substrate is planarized.

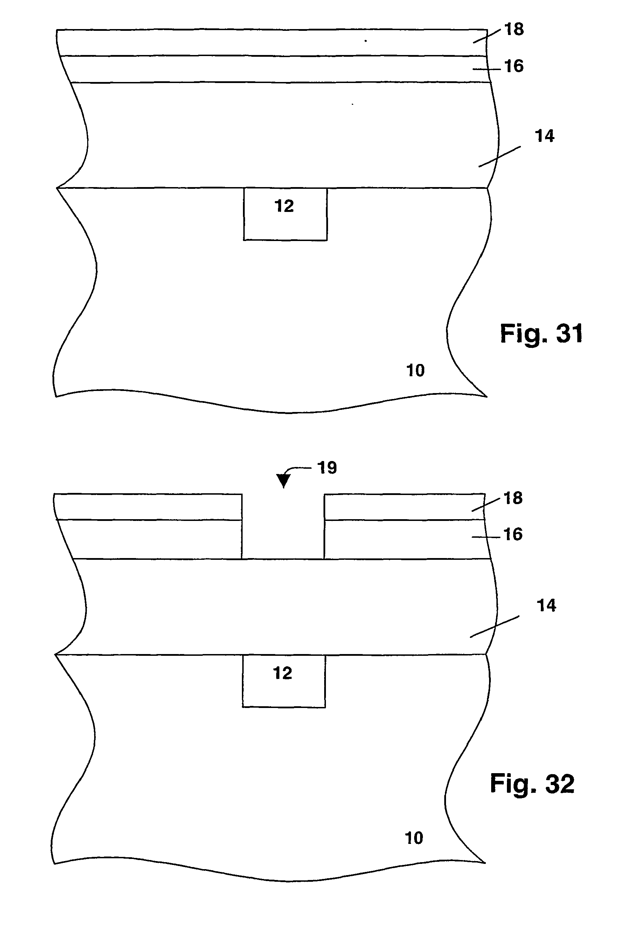

Figure 31 illustrates a cross-sectional view of a semiconductor substrate having a low k material layer and a photoresist layer.

Figure 32 illustrates a cross-sectional view of the semiconductor substrate of Figure 31 after patterning of certain layers.

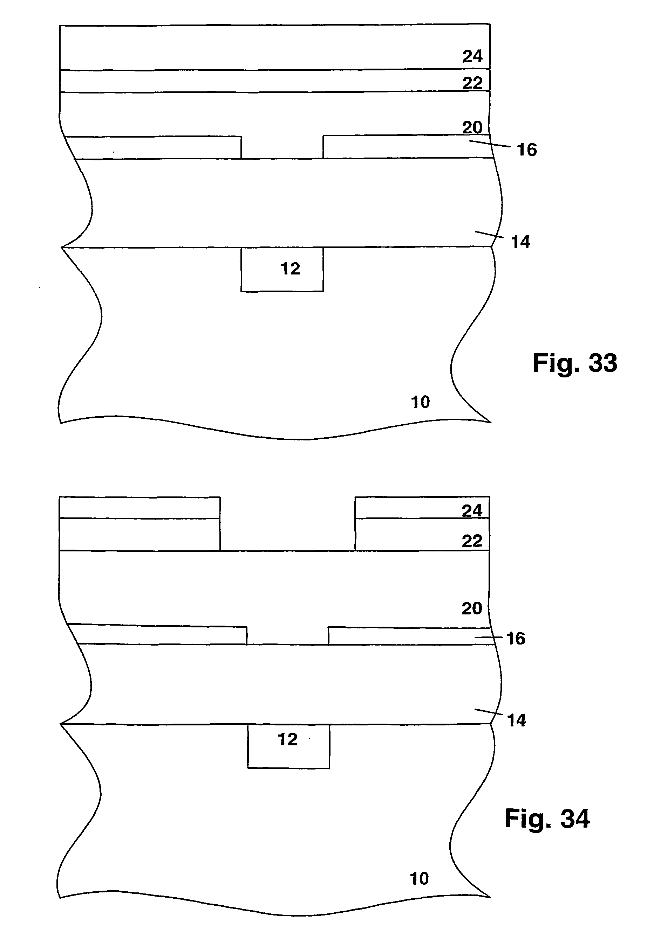

Figure 33 illustrates a cross-sectional view of the semiconductor substrate of Figure 32 after another low k material layer is formed.

Figure 34 illustrates a cross-sectional view of the semiconductor substrate of Figure 33 after patterning of certain layers.

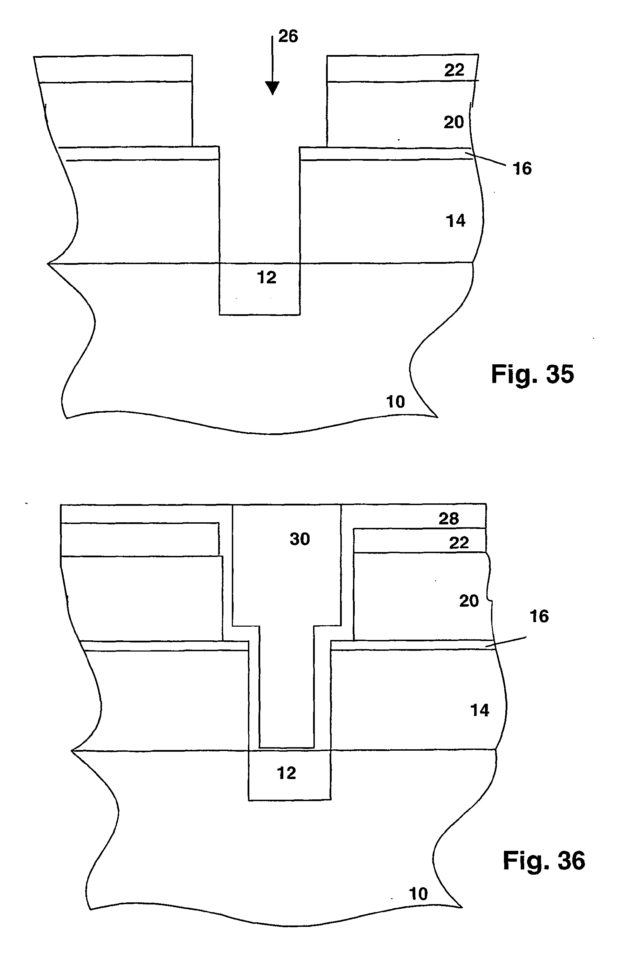

Figure 35 illustrates a cross-sectional view of the semiconductor substrate of Figure 34 after a portion of the low k material is removed.

Figure 36 illustrates a cross-sectional view of the semiconductor substrate of Figure 35 after a barrier layer and a conductive layer are formed.

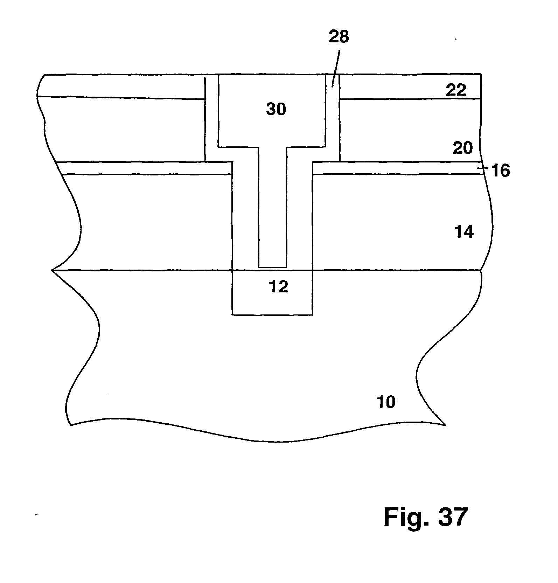

Figure 37 illustrates a cross-sectional view of the semiconductor substrate of Figure 36 after the substrate is planarized.

## MODES FOR CARRYING OUT THE INVENTION

The present invention is now described with reference to the drawings, wherein like reference numerals are used to refer to like elements throughout. In the following description, for purposes of explanation, numerous specific details are set forth in order to provide a thorough understanding of the present invention. It may be evident, however, to one skilled in the art that the present invention may be practiced without these specific details. In other instances, well-known structures and devices are shown in block diagram form in order to facilitate describing the present invention.

The term "component" refers to a computer-related entity, either hardware, a combination of hardware and software, software, or software in execution. For example, a component may be a process running on a processor, a processor, an object, an executable, a thread of execution, a program and a computer. By way of illustration, both an application running on a server and the server can be components. By way of further illustration, both an ion gun and a process controlling an ion gun can be components.

It is to be appreciated that various aspects of the present invention may employ technologies associated with facilitating unconstrained optimization and/or minimization of error costs. Thus, non-linear training systems/methodologies (*e.g.*, back propagation, Bayesian, fuzzy sets, non-linear regression, or other neural networking paradigms including mixture of experts, cerebella model arithmetic computer (CMACS), radial basis functions, directed search networks and function link networks) may be employed.

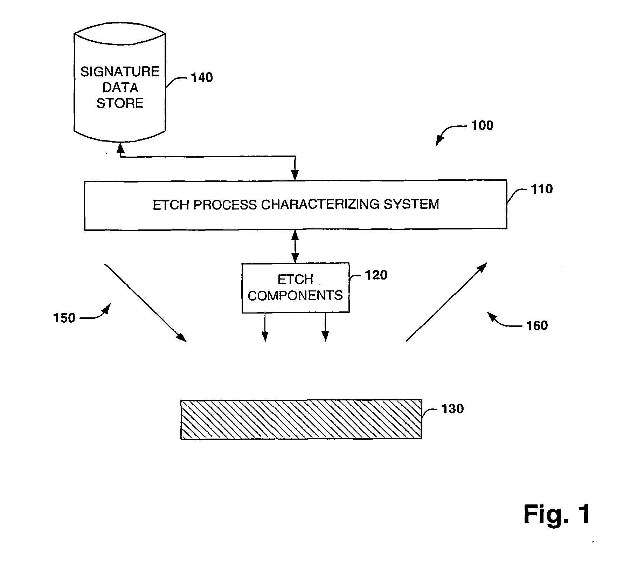

Referring initially to Fig. 1, a system 100 for characterizing an etch process including a dual damascene etch process is illustrated. Such etch processes may be employed, for example, to remove hardened photoresist. While the illustrations associated with this application primarily depict etching occurring directly under one or more etch components, it is to be appreciated that directional etches may also be characterized by the present invention. In plasma etching systems, specific gases are fed into the reaction chamber. There, the plasma creates reactive species from those gases. The etch rate is generally proportional to the concentration of the reactive species. Thus, conventional techniques may employ indirect measurements, including analyzing the reacted gases, to determine etching progress. But such techniques do not provide direct information concerning etch results (*e.g.*, CDs, depths, profiles) being achieved on a wafer 130.

The system 100 includes an etch process characterizing system 110 operative to direct a light 150 at a wafer 130 that is going to be etched or that is in the process of being etched. The etch process characterizing system 110 can be a standalone device and/or can also be distributed between two or more cooperating devices and/or processes. The etch process characterizing system 110 can reside in one physical or logical device (*e.g.*, computer, process) and/or be distributed between two or more physical or logical devices. The etch process characterizing system 110 may include one or more components that are located inside a process chamber and/or one or more components that are not located inside a process chamber. The etch components 120 may be employed, for example, in dry-etching techniques where the mechanism of etching has a physical basis (*e.g.*, glow-discharge sputtering, ion-milling), a chemical basis (*e.g.*, plasma etching), and a combination of bases (*e.g.*, reactive ion etching (RIE), ion-enhanced etching). The etch components 120 may be operatively connected to the etch process characterizing system 110 to supply data concerning current operating characteristics (*e.g.*, temperature, pressure, formula).

The light 150 may be generated by many different light sources, and in one example aspect of the present invention the light 150 is generated by a frequency-stabilized laser. The etch process characterizing system 110 may direct the light 150 at substantially all of the wafer 130 and/or at selected portions of the wafer. By way of illustration, in one example aspect of the present invention, the light 150 may be directed at selected portions of the wafer 130, where such portions provide data sufficient to generate scatterometry signatures. A light 160 reflected from the wafer 130 is collected by the etch process characterizing system 110, which may then employ scatterometry techniques to analyze the reflected light 160 to determine one or more etch results achieved on the wafer 130. For example, the width of lines may be analyzed. Other parameters including, but not limited to horizontal etch rate, vertical etch rate, etch-rate percent uniformity and isotropic versus anisotropic effects may also be analyzed.

It is to be appreciated that the surface of the wafer 130, including features, can both reflect and refract the light 150, so that the light 160 can be a complex reflected and/or refracted light. The scatterometry analysis can include comparing one or more scatterometry signatures associated with the reflected light 160 to one or more scatterometry signatures stored in a signature data store 140. Such signatures may be generated, for example, by combining phase and intensity information associated with the reflected light 160. As etching progresses, light reflecting from a wafer 130 may produce various signatures. The sequence in which such signatures are generated can be employed to determine the rate at which etching is progressing, which can in turn be employed to characterize the etch process. For example, at a first point in time T1, light reflected from the wafer 130 may produce a signature S1 that indicates that lines with a first width W1 have been produced. Similarly, at a second point in time T2, light reflected from the wafer 130 may produce a signature S2 that indicates that lines with a second width W2 have been produced and at a third point in time T3, light reflected from the wafer 130 may produce a signature S3 that indicates that lines with a third width W3 have been produced. Analyzing the sequence of signatures, and the time required to produce transitions between such signatures can facilitate determining whether etching is progressing at an acceptable rate. Furthermore, analyzing the sequence of signatures can be employed to establish cause/effect relationships between adaptations made to etch parameters (*e.g.*, time, temperature, direction, pressure, formula) and etch results (*e.g.*, profile, CDs, depth, etch rate).

Adaptation information can be generated from such sequence analysis to produce suggestions concerning adaptations to be made to one or more etch parameters. For example, a suggestion that one or more reactive ion etching formulae be altered to affect the etching rate based on the signature sequence analysis may be generated. Thus, rather than the conventional etch/break/examine sequence, the present invention facilitates gathering real-time data concerning an etch process, which provides advantages over such conventional systems.

The signature data store 140 can store data in data structures including, but not limited to one or more lists, arrays, tables, databases, stacks, heaps, linked lists and data cubes. The signature data store 140 can reside on one physical device and/or may be distributed between two or more physical devices (*e.g.*, disk drives, tape drives, memory units). Analyses associated with the reflected light 160 and/or the signatures stored in the signature data store 140 can be employed to suggest adaptations to one or more etching components 120. It is to be appreciated that the etching components 120 can include, but are not limited to, etching components associated with descum etch steps performed before a main etch, PR trim etch steps, BARC (breakthrough antireflective coating) etch steps and main etch steps. It is to be further appreciated that the etching components 120 can be employed to remove exposed regions of a positive photoresist mask and/or unexposed regions of a negative photoresist mask using techniques like reactive ion etching, for example.

The precision with which resist portions are removed to create fine line patterns and the resulting precision in the distance between the remaining portions corresponds to the precision with which desired profiles, depths, CDs, etc. are achieved. Therefore, the precision of the processing performed by the etch components 120 is directly related to the feature sizes and CDs that can be achieved on the wafer 130. Gathering real time etch process data facilitates determining the effect of controlling the etch components 120 and thus facilitates more quickly and more accurately determining desired etch component 120 adaptations that will result in higher quality ICs.

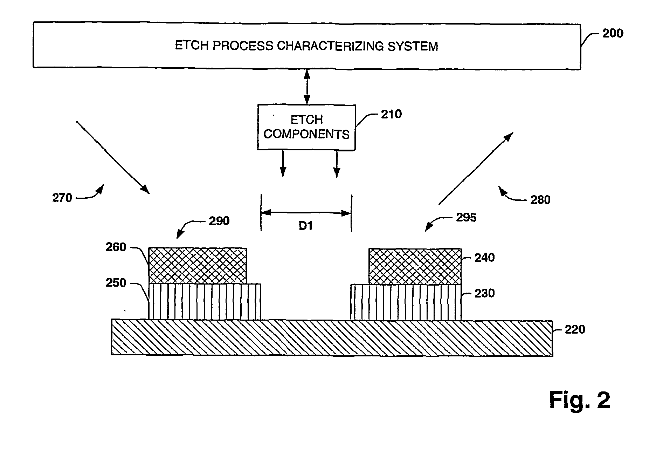

Turning now to Fig. 2, an etch process characterizing system 200 is illustrated directing a light 270 at a wafer 220 and receiving back a reflected light 280. The etch process characterizing system 200 can be a standalone device and/or can also be distributed between two or more cooperating devices and/or processes. The etch process characterizing system 200 can reside in one physical or logical device (*e.g.*, computer, process) and/or be distributed between two or more physical or logical devices. The etch process characterizing system 200 may include one or more components that are located inside a process chamber and/or one or more components that are not located inside a process chamber.

The reflected light 280 will be affected by factors including, but not limited to the chemical properties of the wafer 220 and/or the layers on the wafer 220, the size, shape and location of features on the wafer 220, the size, shape and location of gratings on the wafer 220 and the size, shape and location of spaces between such features. By way of illustration, different materials that may be etched, (*e.g.*, refractory metal silicides, polycides, aluminum, aluminum alloys, polysilicon, silicon nitride and silicon dioxide) may have different chemical properties that affect the reflected light 280. By way of further illustration, a gap D1 between a first feature 290 and a second feature 295 is illustrated. The first feature 290 is illustrated as having an oxide layer 250 substantially covered by a hardened photoresist layer 260. Similarly, the second feature 295 is illustrated as having an oxide layer 230 substantially covered by a hardened photoresist layer 240. One or more etching components 210 are illustrated operatively connected to the etch process characterizing system 200. Such operative connection facilitates the etching components 210 providing information concerning operating parameters (*e.g.*, temperature, formula, angle, direction, pressure) associated with the etch components 210. The etch components 210, which may be one or more of a variety of etch components known in the art can be employed to remove oxide that is not protected by the hardened resist layers 260 and 240. Thus, portions of the oxide layer 250 and 230 may be removed as a result of etch processes associated with the etch components 210. The rate at which the oxide layers 250 and 230 are removed and the precision with which they are removed can produce one or more measurable etch results (*e.g.*, CDs, depth, profile) that can be analyzed *via* the reflected light 280.

The gap D1 and/or the geometry of the layers 230, 240, 250 and 260 and/or the relationships between the geometry of the layers 230, 240, 250 and 260 can be measured by the etch process characterizing system 200 to determine cause/effect relationships between operating parameters (*e.g.*, temperature, formula, angle, direction, pressure) associated with the etch components 210 and results achieved on the wafer 220. For example, a signature associated with the gap D1 and the geometry of the layers 230, 240, 250 and 260 may indicate that a first set of operating parameters produced a first etch result. Furthermore, the results may indicate that further adaptation of the operating parameters of the etching components 210 may be desired. Thus, information operable to determine suggested adjustments to the etch components 210 may be generated by the etch process characterizing system 200.

As etching of the wafer 220 progresses, light reflecting from the wafer 220 and/or the features 290 and 295 may produce various signatures. The sequence in which such signatures are generated can be employed to determine the rate at which etching is progressing. Similarly, the sequence in which such signatures are generated can be employed to determine cause/effect relationships between adaptations to the etch components 210 and etch results monitored on the wafer 220.

By way of illustration, at a first point in time T5, light reflected from the wafer 220 and/or the features 290 and 295 may produce a signature S5 that indicates that the gap D1 has reached a first measurement. At that point in time T5, an adaptation may be made to one or more of the etch components 210. Thus, at a second point in time T6, light reflected from the wafer 220 and/or the features 290 and 295 may produce a signature S6 that indicates that the gap D1 has reached a second measurement, and thus a direct correlation can be made between the adaptations to the etch components 210 and the sequence of signatures {S5, S6}.

To determine the optimal adaptation to be made at the point in time T5, the etch process that leads to the conditions at T5 may be replicated, and then a different adaptation may be made at the second first point in time T5. Then at a second second point in time T7, light reflected from the wafer 220 may produce a signature S7 that indicates that the gap D1 has reached a third measurement. Thus, the difference sequence of signatures {S5,S6} and {S5,S7} can be employed to determine the optimal adaptation at time T5 in the etch process being characterized. Such real time imaging of the etch results provides advantages over the conventional etch/break/ examine sequence.

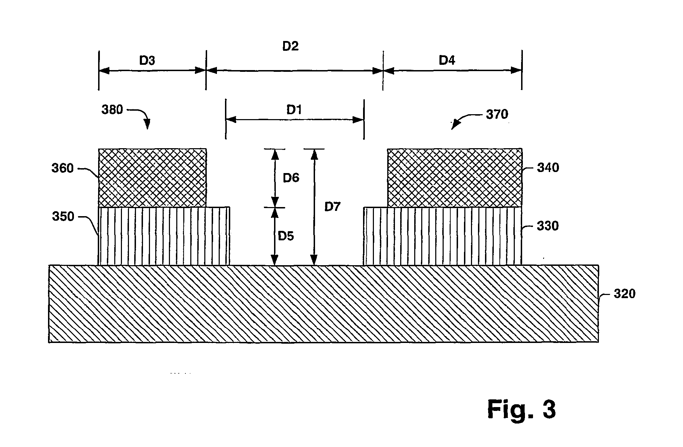

Turning now to Fig. 3, measurements that may affect signatures generated by a scatterometry system associated with characterizing an etch process are illustrated. Controlling such measurements (*e.g.*, gate width and thickness, linewidth and thickness) can be important to reliable and efficient operation of an integrated circuit. For example, both gate delay and drive current are proportional to the inverse of the gate length. Thus, gate lengths should be tightly controlled across chips and wafers to facilitate correlating and sequencing signals. A wafer 320 is illustrated with two features 370 and 380. The feature 370 is illustrated with an oxide layer 330 and a hardened photoresist layer 340. Similarly, the feature 380 is illustrated with an oxide layer 350 and a hardened photoresist layer 360. While the oxide layers 350 and 330 are separated by a distance D1, this distance may, for example, be too small for reliable operation of the integrated circuit being fabricated on the wafer 320 or to allow for the creation of a subsequent intervening feature in the gap measured by D1.

A desired critical dimension for the distance between the oxide layer 250 and the oxide layer 330 may be the distance D2. For example, a gap of size D2 may be required to facilitate fabricating a subsequent feature that will reside between the features 370 and 380. Lithography sufficient to harden the photoresist layer 360 and the photoresist layer 370 may have been achieved in earlier fabrication steps, but such precise lithography may go to waste if precise etching of the features 370 and 380 can not be achieved. For example, sophisticated lithography may have produced the hardened photoresist 360 with a desired width of D3. Similarly, sophisticated lithography may have produced the hardened photoresist layer 340 with have a desired width of D4, which should suffice to facilitate etching the oxide layers 350 and 330 if precise etching control is possible. But if precise etching control is not possible, then the distance D1 may be maintained, and reliable operation may not be achieved and/or the intervening feature may not be able to be created. While the distances D1 through D4 are illustrated as horizontal distances, it is to be appreciated that distances in other directions (*e.g.*, vertical distances D5, D6, D7, angular distances, etc), may also be analyzed in accordance with the present invention.

Thus, the present invention facilitates generating information concerning the distances D1, D2, D3, D4, D5 and D6 and the resulting topographies of resist and oxide layers. A scatterometry-based real time image of the features 370 and 380 can be employed to characterize an etch process, and to determine the desirability of adaptations to one or more etch parameters (*e.g.*, temperature, formula, angle, direction, pressure). Such information, generated, at least in part, in response to *in situ* reflected light being analyzed by scatterometry techniques can be employed to generate process history data that can be employed to adapt future etch processes that are characterized by machine learning techniques that have access to such history data, thus providing advantages over conventional systems. For example, one or more signatures associated with the wafer 320 and/or the features 370 and 380 can be generated. At a first point in time T10, a signature S10 may be generated that indicates that desired critical dimensions have not been achieved. Thus, an etching process may be adapted in an attempt to achieve the desired critical dimension. Then, at a second point in time T11, a signature S11 may be generated that indicates that although the desired critical dimensions have still not been achieved, that progress toward the desired critical dimensions have occurred. Thus, the adaptation undertaken at T10 can be identified as a beneficial adaptation. The etching process may then be continued until a later point in time T12, when a signature S12 indicates that the desired critical dimensions have been achieved. Thus, a cause and effect relationship between the adaptation at T10 and the signature sequence {S10, S11, S12} may be determined. But the signature S11 may have indicated that the adaptation to the etching process produced a movement away from desired critical dimensions. Thus, the adaptation at T10 may be identified as an undesirable adaptation and future etch processes may not attempt the same adaptation.

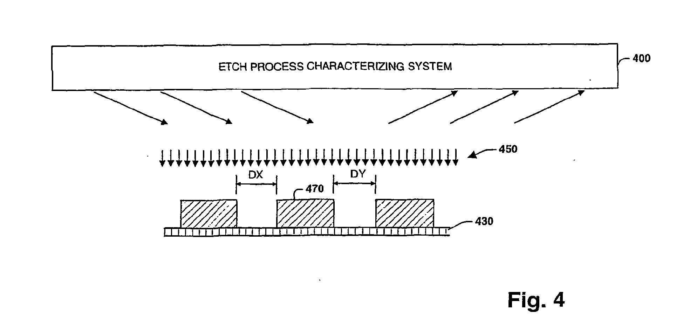

Turning now to Fig. 4, an etch process characterizing system 400 is illustrated monitoring an etch process 450 being applied to a wafer 430, whereupon one or more features 470 are being etched. While features 470 are illustrated, it is to be appreciated that gratings may also be analyzed in accordance with the present invention. It is to be appreciated that the etch process 450 may be performed by etching components associated with etch steps performed before a main etch (*e.g.*, descum etch), PR trim etch steps, BARC (breakthrough anti-reflective coating) etch steps and main etch steps and that the etching components may provide feedback data concerning current operating conditions (*e.g.*, time, temperature, heat, pressure, angle, direction) to the etch process characterizing system 400. The etch process 450 can be monitored by the etch process characterizing system 400, for example, to acquire scatterometry signatures associated with the widths DX and DY and the effect of one or more adaptations to the etch process 450 on the widths DX and DY and/or the rate of change of DX and/or DY based on the adaptations. Retrieving a real time image of the etch profile *via in-situ* retrieval and/or analysis of information concerning direct measurements of the widths DX and DY, and/or similar information from one or more gratings, and producing adaptation data that can be employed to adapt the etch process 450, and/or other etch processes, facilitates achieving more precise CDs and thus provides advantages over conventional systems. By way of illustration, conventional laser reflectance monitoring methods do not provide *in situ* etch rate information. By way of further illustration, in laser interferometry methods, the laser must be focused on an open flat region, thus prime wafer real estate is sacrificed for the testing area. Also, such laser interferometry methods may only provide information on a limited area of the wafer surface.

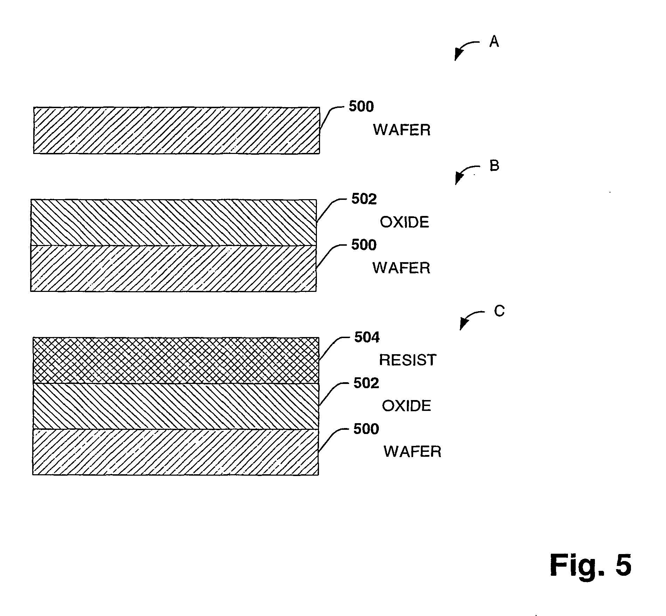

Turning now to Fig. 5, a wafer 500 is illustrated. The wafer 500, at a step A in an IC manufacturing process, initially is not covered with layers of oxides and/or resists. At a step B in the manufacturing process, the wafer 500 is covered with an oxide layer 502. The oxide layer 502 is employed in constructing one or more features on the wafer 500. At a later step C in the manufacturing process, a resist layer 504 is deposited on top of the oxide layer 502. The resist layer 504 is employed to enable selective removal of portions of the oxide layer 502, thus facilitating constructing one or more features on the wafer 500. The ability to precisely control the selective removal facilitates achieving desired feature profiles and leads to improvements in IC quality.

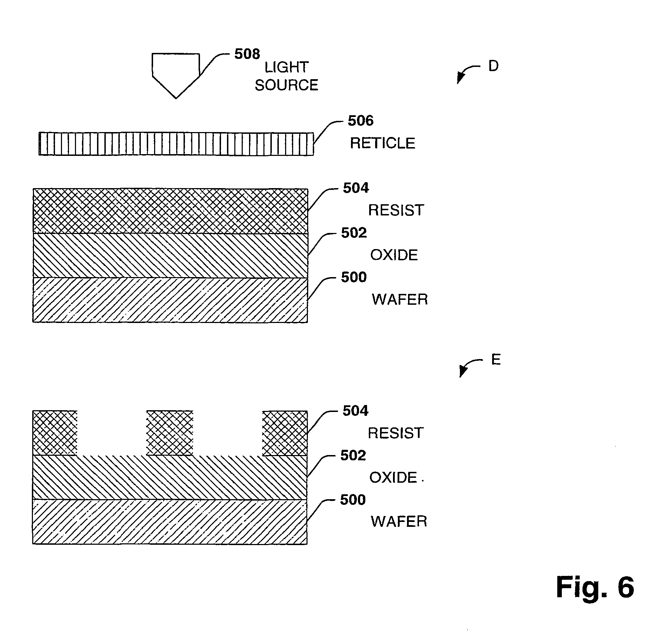

Turning now to Fig. 6, at a step D in the manufacturing process, the wafer 500 (with the oxide layer 502 and the resist layer 504) is exposed to a light source 508 through a reticle 506. The reticle 506 facilitates exposing only selected portions of the resist layer 504 to light from the light source 508. Portions of the resist layer 504 that were exposed to light from the light source 508 may be developed and hardened, while portions of the resist layer 504 not exposed to the light from the light source 508 may not develop, and may remain susceptible to removal by various processes. At a subsequent step E in the manufacturing process, the non-hardened portions of the resist layer 504 may be removed, exposing portions of the oxide layer 502. At step E, illustrated in Fig. 6, the resist layer 504 has had two sections removed, leaving three areas of resist. The precision with which the resist portions can be removed, and the resulting precision in the distance between the remaining portions can be important to achieving desired feature profiles, by providing precise fields to be etched. Gathering a real time image of the resist as it is processed facilitates characterizing an etch process. Rather than employing a conventional etch/break/examine cycle, real time images of the resist 504 may be employed to determine whether an etch process is producing desirable results and thus may similarly be employed to determine whether adaptations to the etch process are desired. Such real time image analysis and resulting adaptations can be made at an earlier point in time than is possible in the conventional etch/break/examine cycle, and thus advantages in speed, accuracy and causation (*e.g.*, cause/effect) may be achieved.

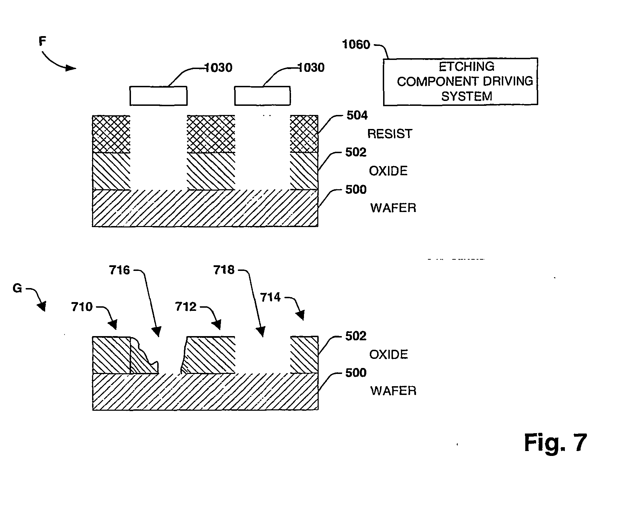

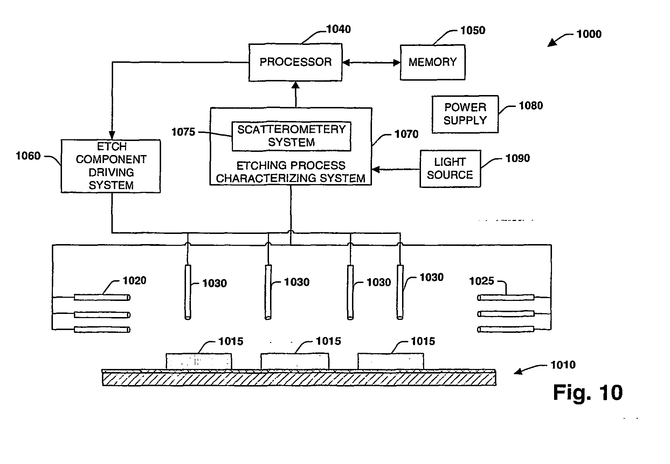

Thus turning to Fig. 7, portions of the oxide layer 502 that are not covered by hardened portions of the resist layer 504 can be etched away by one or more etching components 1030 (Fig. 10) at a later manufacturing step F. Etching away precise amounts of the oxide layer 502 from precise locations facilitates achieving desired feature profiles. For example, a feature 710 can be separated from a feature 712 by a space 716. Precise etching can facilitate controlling the shape and/or size of the feature 712 to facilitate controlling the shape and/or size of the space 716 between the feature 710 and the feature 712, which can lead to increases in packing densities and improved feature profiles. Similarly, the feature 712 can be separated from a feature 714 by a space 718 whose size and/or shape can likewise be precisely controlled. Conventionally, the image produced by the features 710, 712 and 714 and the spaces 716 and 718 may not be examined until the end of the etching process. Thus, intermediate results that may affect the quality of the IC may not be examined. By providing real time imagery of the features 710, 712 and 714 and the spaces 716 and 718, such intermediate results may not be ignored, with resulting increases in IC quality.

Although three features 710, 712 and 714 are illustrated in Fig. 7, it is to be appreciated that a greater or lesser number of features can be etched by systems employing the present invention. The present invention facilitates determining whether a feature profile (*e.g.*, the sloped portion on the right side of feature 710) matches a desired feature profile and thus facilitates generating feedback information that can be employed to suggest adaptations to the etching process being characterized by the present invention.

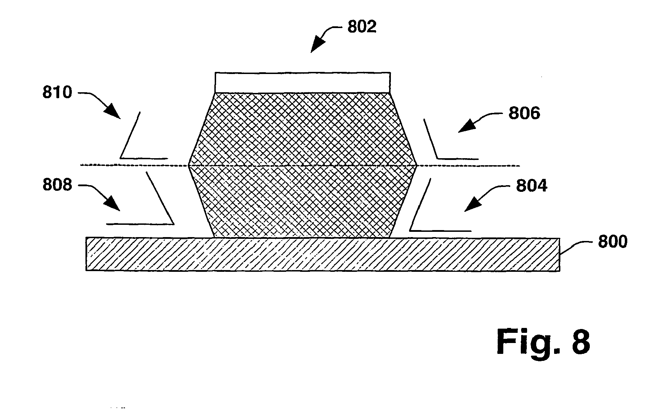

Fig. 8 presents a feature 802 with a multi-slope profile fabricated on a wafer 800. Etch techniques for constructing the feature 802, including multi-layer techniques are known in the art, but characterizing and/or monitoring such techniques may involve the conventional etch/break/examine cycle. Thus, intermediate adjustments that may facilitate higher quality profiles may not be made. Thus, the etching techniques may benefit from *in situ* monitoring, which facilitates producing real-time imagery to facilitate understanding the etch processes involved in creating the feature 802. By way of illustration, the angle 810 may vary depending on the angle 808. As angle 808 becomes more acute, the feature 802 may benefit from the angle 810 being more acute. Similarly, the angle 806 may depend on the angle 810. As the angle 810 becomes more acute, feature 802 may benefit from the angle 806 becoming more obtuse. Thus, by monitoring signatures associated with light reflected from the feature 802 and/or the wafer 800 during the fabrication process, etch processes that affect subsequent dependent angles may be better understood. Thus, adapting the etch process in response to real time imagery associated with preceding controlling angles, which may vary from feature to feature, or wafer to wafer due to intra-wafer variations and/or wafer to wafer variations, provides advantages over conventional systems.

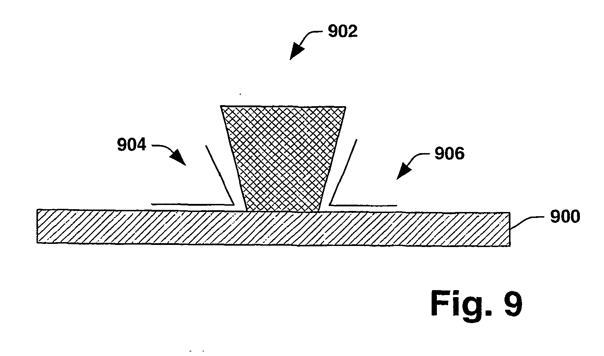

Fig. 9 presents a feature 902 with a multi-slope profile fabricated on a wafer 900. The geometry of the feature 902 is more complicated than the geometry of a rectangular feature, for example. Thus, more complicated etch techniques may be required to fabricate the feature 902. Techniques for constructing the feature 902 are known in the art, but such techniques, which may have been developed through the conventional etch/break/examine cycle may benefit from *in situ* monitoring, which facilitates producing real-time feedback that can be employed to better understand, and thus adapt the fabrication process. By way of illustration, the angles 904 and 906 may vary depending on the height of the feature 902. As the feature 902 becomes taller, the feature 902 may benefit from the angle 904 being more obtuse and the angle 906 being more obtuse. Thus, by monitoring signatures associated with light reflected from the feature 902 and/or the wafer 900 during the fabrication process, etching parameters (*e.g.*, time, temperature, pressure, direction, angle) that affect fabricating dependent angles may be adapted in response to developing controlling parameters (*e.g.*, height), which may vary from feature to feature, or wafer to wafer due to intra-wafer variations and/or wafer to wafer variations, for example. Being able to monitor a variation during fabrication (*e.g.*, height of feature 902) facilitates adapting an etching process to account for intermediate results that may not be observable through conventional methods. Additionally and/or alternatively, data collected while monitoring the formation of the feature 902 can be employed to facilitate reproducing and/or adapting process conditions in subsequent fabrication processes employed to create features similar to feature 902. Thus, adaptive learning techniques can be employed to improve semiconductor feature manufacture, providing advantages over conventional systems.

Fig. 10 illustrates a system 1000 for producing a real time image of a profile that can be employed in characterizing an etch process. The system 1000 operates to monitor one or more etch components 1030 and a wafer 1010 whereupon one or more features and/or gratings 1015 are located in order to understand etch processes and thus to facilitate mitigating fabricating poorly etched features and wafers. An etching process characterizing system 1070, a processor 1040 and an etch component driving system 1060 work cooperatively to control the etch components 1030 and to provide feedback information concerning the etch component 1030 operating parameters (*e.g.*, temperature, formula, angle, direction, pressure).

The etch components 1030 are coupled to and controlled directly by the etch component driving system 1060. The etch component driving system 1060 receives information and/or instructional commands from the processor 1040. The processor 1040 determines the content and type of information transmitted to the etch component driving system 1060 according to its analysis of data received from and collected by the characterizing system 1070. Thus, through the interaction of components 1030, 1070, 1040 and 1060, the system 1000 has the ability to generate real time images of the wafer 1010 and thus to facilitate altering subsequent etch processes for the same wafer and/or for subsequent wafers. In addition, by communicating measurements relating to recently etched features/wafers to the processor 1040, the processor 1040 can control the etching component driving system 1060, which can thus regulate the one or more etching components 1030 to facilitate obtaining more precise and improved etching processes. Thus etching errors can be mitigated and higher packing densities and smaller feature sizes can be achieved.

The system 1000 includes one or more etching components 1030 that are selectively controlled to facilitate controlled etching of the wafer 1010. One or more target light sources 1020 project light onto respective portions of the wafer 1010. A portion of the wafer 1010 may have one or more gratings 1015 and/or features located on that portion. Light reflected and/or refracted by the one or more gratings 1015 is collected by one or more light detecting components 1025, and processed by an etching process characterizing system 1070 to measure at least one parameter relating to the etching of one or more features and/or the one or more gratings 1015. For example, spaces between portions of the grating 1015 and spaces between the gratings 1015 can be measured and compared to desired critical dimensions (CDs). The reflected light is measured with respect to the incident light in order to obtain the various parameters relating to the gratings 1015.

The characterizing system 1070 includes a scatterometry system 1075. It is to be appreciated that any suitable scatterometry system may be employed to carry out the present invention, and such systems are intended to fall within the scope of the claims appended hereto. In one specific embodiment, the etching process characterizing system 1070 is a dual damascene etch process characterizing system.

A light source 1090 (*e.g.*, a laser) provides light to the one or more target light sources 1020 *via* the characterizing system 1070. Preferably, the light source 1090 is a frequency-stabilized laser, however, it will be appreciated that any laser or other light source (*e.g.*, laser diode or helium neon (HeNe) gas laser) suitable for carrying out the present invention may be employed. One or more light detecting components 1025 (*e.g.,* photo detector, photo diodes) collect light reflecting from the one or more gratings 1015 and/or the one or more features being etched. The characterizing system 1070 may also process the measured light data into a data form compatible with or understandable to the processor 1040.

The processor 1040 is operatively coupled to the characterizing system 1070 and receives the measured etching parameter data from the characterizing system 1070. The processor 1040 records the acceptability of etching measurements associated with the respective portions of the wafer 1010 by examining measured etch results and comparing such measured etch result values to stored acceptable and unacceptable etch result values. The etch result values may be associated with one or more signatures stored, for example, in a memory 1050. In determining the acceptability and/or progress of an on-going and/or recently completed etch process, the processor 1040 may also determine to what extent, if any, adjustments to the etching components 1030 may affect subsequent etch processes. Upon making the determination, the processor 1040 may provide suggested adaptations to the etch process. In one example of the present invention, the processor 1040 transmits this information to the etch component driving system 1060, which then makes one or more adjustments to the etching components 1030 for a subsequent iteration of the etch process characterization method.

As described above, the processor 1040 is also coupled to the etching component driving system 1060 that directs and controls the one or more etching components 1030. The etching component driving system 1060 is controlled, at least in part, by the processor 1040 to selectively vary the operation of the respective etching components 1030. Each respective portion of the wafer 1010 is associated with a corresponding etching component 1030. The processor 1040 monitors the etching of one or more features and/or one or more gratings 1015, and selectively regulates the etching of each portion *via* the corresponding etching components 1030. The transmission and relay of information between the characterizing system 1070, the processor 1040, the etch component driving system 1060 and the etch components 1030 facilitates receiving effective feed back information (*e.g.*, real time imagery coupled with operating parameters that produced the image) that in turn facilitates improving IC quality by more quickly and more accurately characterizing etch process that facilitates adapting such etch processes to produce more precisely etched features.

The processor 1040, or central processing unit, may be any of a plurality of commercially available processors. The processor 1040 is programmed to monitor, control and operate the various components within the system 1000 in order to carry out the various functions described herein. The manner in which the processor 1040 is programmed to carry out the functions relating to the present invention will be apparent to those having ordinary skill in the art based on the description provided herein.

A memory 1050, which is operatively coupled to the processor 1040, is also included in the system 1000 and serves to store, among other things, program code executed by the processor 1040 for carrying out operating functions of the system 1000 as described herein. For example, the memory 1050 can hold patterns to which observed data can be compared. The memory 1050 also serves as a storage medium for temporarily storing etching parameter data such as etching progress values, etching progress tables, component coordinate tables, grating sizes, grating shapes, scatterometry information, etch measurements (*e.g.*, CDs, depth, profile info) and other data that may be employed in carrying out the present invention.

A power supply 1080 provides operating power to the system 1000. Any suitable power supply (*e.g.*, battery, line power) may be employed to carry out the present invention.

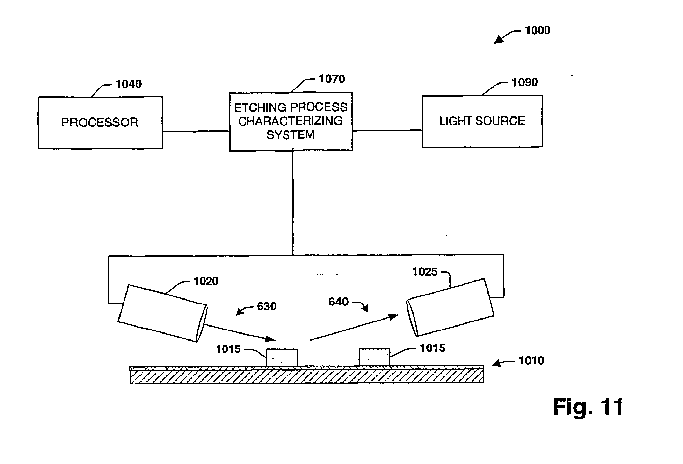

Turning now to Fig. 11, one aspect of the present invention is shown. Fig. 11 illustrates the system 1000 being employed to measure the etching of a particular portion of the wafer 1010. The target light source 1020 directs a light 630 incident to the surface of the wafer 1010. The angle of a reflected light 640, reflected from the surface of the wafer 1010 will vary in accordance with the evolving dimensions of the gratings 1015, and/or with the evolving dimensions of one or more features being etched in the wafer 1010. Thus, by comparing the evolving dimensions of the one or more features and/or gratings 1015, cause/effect relationships between etch process operating parameters (*e.g.*, temperature, pressure, time, formula, direction, angle) and etch results can be understood and stored. The one or more light detecting components 1025 collect the reflected light 640 and transmit the collected light, and/or data associated with the collected light, to the characterizing system 1070. The characterizing system 1070 collects the reflected light 640, and/or related data, in accordance with scatterometry techniques. The characterizing system 1070 then provides the processor 1040 with the data corresponding to the etching characteristics associated with the wafer 1010. The data may include, for example, information relating to the dimensions of etched areas relative to, or independent of, dimensions of unetched areas, and/or surface characteristics as well as other measurements relating to the etch process. In one example of the present invention, such relationships may be employed in linear and/or non-linear machine learning techniques to adapt etch processes characterized by the present invention.

The etch process characterizing system 1070 may provide direct, real-time measurements to the processor 1040, as opposed to measurements taken according to pre-determined system schedules and measurements taken post-fabrication as is customary in conventional systems. Providing direct, real-time feedback to the processor 1040 facilitates selective adaptation of etch processes and improved etching precision over conventional methods and/or apparatus.

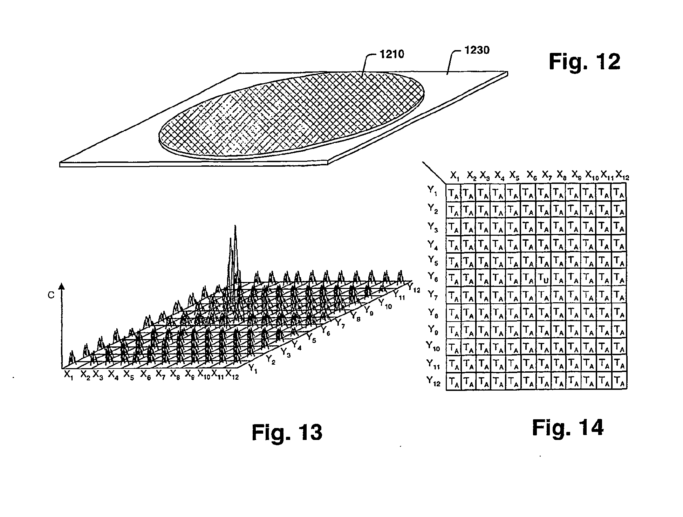

Turning now to Figs. 12-14, another aspect of the present invention is shown. In addition to the methods described above, a wafer 1210 may be logically partitioned into grid blocks to facilitate identifying positions or locations associated with characterizing the etch process. Obtaining such positions or locations may facilitate determining to what extent, if any, etch process parameter adjustments are necessary. Obtaining such information may also assist in determining problem areas associated with etch processes.

Fig. 12 illustrates a perspective view of a chuck 1230 supporting the wafer 1210, whereupon one or more features and/or gratings may be formed. The wafer 1210 may be divided into a grid pattern as shown in Fig. 13. Each grid block (XY) of the grid pattern corresponds to a particular portion of the wafer 1210, and each grid block is associated with one or more gratings and/or one or more portions of one or more gratings. The grid blocks are individually monitored for etch results and etching parameters associated with each grid block may similarly be individually monitored and/or recorded which facilitates establishing cause/effect relationships. It is to be appreciated that the size and/or shape of gratings can be manipulated to facilitate analyzing different etch results. For example, for a particular layer in an integrated circuit, a CD relating to a width between features may be important. Thus, the gratings can be patterned to optimize analyzing the width between features.

In Fig. 13, one or more gratings in the respective portions of the wafer 1210 ($X_1Y_1$ ... $X_{12}$, $Y_{12}$) are monitored for CDs produced during the etch process using reflected light, the characterizing system 1070 (Fig. 10) and the processor 1040 (Fig. 10). Exemplary CD measurements produced during etching for each grating are shown. As can be seen, the CD measurement at coordinate $X_7Y_6$ is substantially higher than the CD measurement of the other portions XY. It is to be appreciated that the wafer 1210 may be mapped into any suitable number of grid blocks, and any suitable number of gratings may formed on the wafer 1210. Although the present invention is described with respect to one etching component 1030 corresponding to one grid block XY, it is to be appreciated that any suitable number of etching components 1030 corresponding to any suitable number of wafer portions/grid blocks may be employed.

Fig. 14 is a representative table of CD measurements taken for the various grid blocks that have been correlated with acceptable CD values for the portions of the wafer 1210 mapped by the respective grid blocks. As can be seen, all the grid blocks, except grid block $X_7Y_6$, have CD measurements corresponding to an acceptable CD table value ($T_A$) (*e.g.,* are within an expected range of etching measurements), while grid block $X_7Y_6$ has an undesired CD table value ($T_U$). Thus, the processor 1040 has determined that an undesirable etching result exists at the portion of the wafer 1210 mapped by grid block $X_7Y_6$. Accordingly, the processor 1040 may suggest one or more adaptations for at least an etching component $1030_{7,6}$, which corresponds to the portion of the wafer 1210 mapped at grid block $X_7Y_6$, to attempt to produce an acceptable CD.

The measurements illustrated in Fig. 13 and the corresponding determinations illustrated in Fig. 14 can be employed together to produce a real time image of the acceptability of an etch process. Thus, rather than waiting until the end of a conventional etch/break/examine sequence, an etch process being characterized through such real-time imagery may be examined and/or terminated at an earlier point in time, producing time savings over conventional systems.

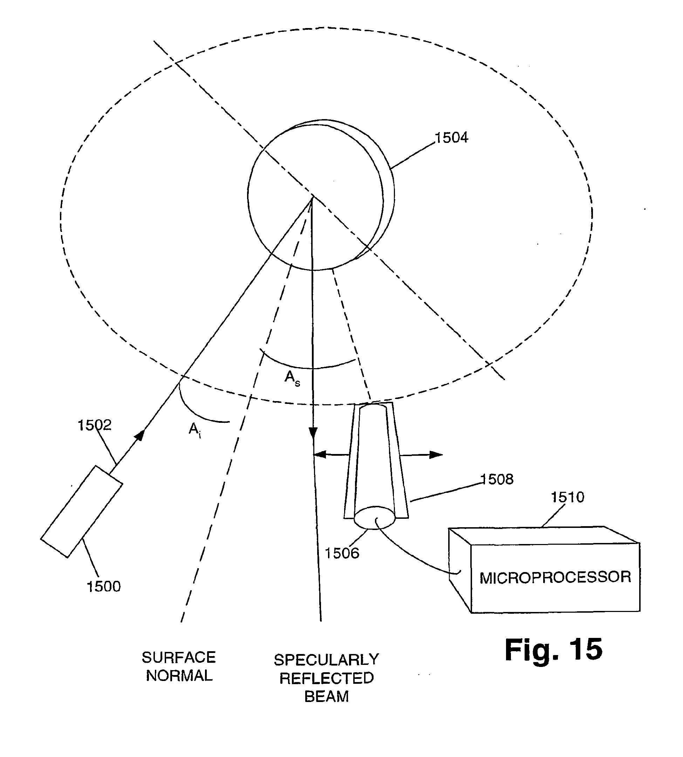

Fig. 15 illustrates an exemplary scatterometry system collecting reflected light. Light from a laser 1500 is brought to focus in any suitable well-known manner to form a beam 1502. A sample, such as a wafer 1504, is placed in the path of the beam 1502 and a photo detector or photo multiplier 1506 of any suitable well-known construction. Different detector methods may be employed to determine the scattered power. To obtain a grating pitch, the photo detector or photo multiplier 1506 may be mounted on a rotation stage 1508 of any suitable well-known design. A microprocessor 1510, of any suitable well-known design, may be used to process detector readouts, including, but not limited to, angular locations of different diffracted orders leading to diffraction grating pitches being calculated. Thus, light reflected from the sample 1504 may be accurately measured.

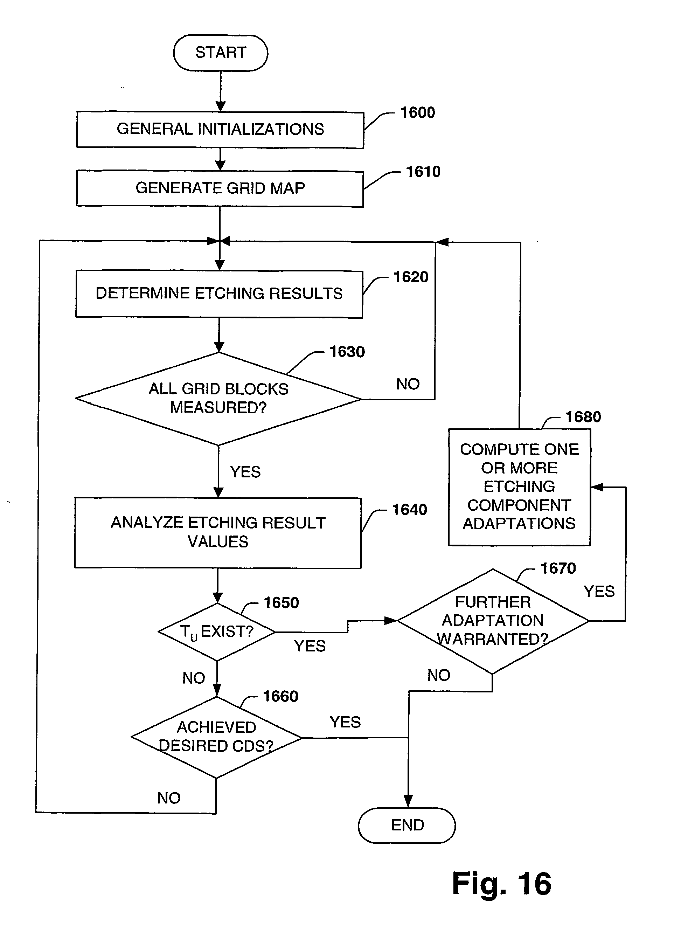

In view of the exemplary systems shown and described above, methodologies that may be implemented in accordance with the present invention will be better appreciated with reference to the flow diagram of Fig. 16. While for purposes of simplicity of explanation, the methodology of Fig. 16 is shown and described as a series of blocks, it is to be understood and appreciated that the present invention is not limited by the order of the blocks, as some blocks may, in accordance with the present invention, occur in different orders and/or concurrently with other blocks from that shown and described herein. Moreover, not all illustrated blocks may be required to implement a methodology in accordance with the present invention.

Fig. 16 is a flow diagram illustrating one particular methodology for carrying out the present invention. At 1600, general initializations are performed. Such initializations can include, but are not limited to, establishing pointers, allocating memory, setting variables and establishing communication channels. At 1610, a grid map of a plurality of grid blocks "XY" is created. At 1620, etching results are measured from various wafer portions mapped by the respective grid blocks XY. At 1630, a determination is made concerning whether all grid block measurements have been taken. If the determination at 1630 is NO, then processing returns to 1620. If the determination at 1630 is YES, then at 1640, determined etching result values are analyzed and compared against stored etching result values for the respective portions of a wafer. In an alternative example of the present invention, the determination at 1630 may concern whether a sufficient number of grid blocks have been measured to facilitate valid analysis.

At 1650, a determination is made concerning whether etching values are unacceptable. If etching values are acceptable, then processing continues at 1660 where a determination is made concerning whether desired CDs have been achieved. If desired CDs have been achieved, then processing can conclude. Otherwise, processing continues at 1620. If unacceptable values are found at 1650, processing proceeds to 1670 where a determination is made concerning whether further adaptation to the etching process being characterized is warranted. By way of illustration, the unacceptable values may indicate that portions of the wafer and/or the entire wafer being processed have been damaged to such an extent that further adaptations to the etch process are unwarranted. By way of further illustration, analysis of the unacceptable dimensions may indicate that a simple adaptation is appropriate. At 1680, one or more suggestions for adaptations to the etching components may be computed. The present iteration is then ended and the process returns to 1620 to perform another iteration.

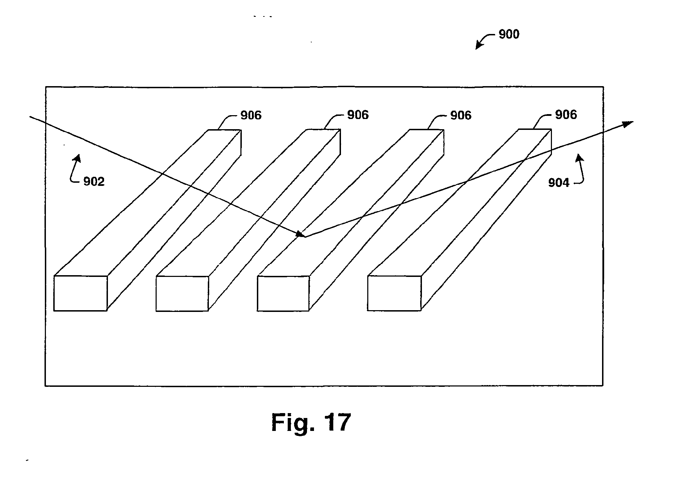

Turning now to Figs. 17-22, the concept of scatterometry and how it is employed in the present invention is discussed. Scatterometry is a technique for extracting information about a surface upon which an incident light has been directed. Scatterometry is a metrology that relates the geometry of a sample to its scattering effects. Scatterometry is based on the reconstruction of the grating profile from its optical diffraction responses. Information concerning properties including, but not limited to, dishing, erosion, profile, thickness of thin films and critical dimensions of features present on the surface can be extracted. The information can be extracted by comparing the phase and/or intensity of the light directed onto the surface with phase and/or intensity signals of a complex reflected and/or diffracted light resulting from the incident light reflecting from and/or diffracting through the surface upon which the incident light was directed. The intensity and/or the phase of the reflected and/or diffracted light will change based on properties of the surface upon which the light is directed. Such properties include, but are not limited to, the chemical properties of the surface, the planarity of the surface, features on the surface, voids in the surface, and the number and/or type of layers beneath the surface. In the present invention, the intensity and/or phase of the reflected and/or diffracted light will be examined as it relates to critical dimensions desired on the wafer being etched.

Different combinations of the above-mentioned properties will have different effects on the phase and/or intensity of the incident light resulting in substantially unique intensity/phase signatures in the complex reflected and/or diffracted light. Thus, by examining a signal (signature or stored value) library of intensity/phase signatures, a determination can be made concerning the properties of the surface. Such substantially unique phase/intensity signatures are produced by light reflected from and/or refracted by different surfaces due, at least in part, to the complex index of refraction of the surface onto which the light is directed. The complex index of refraction (N) can be computed by examining the index of refraction (n) of the surface and an extinction coefficient (k). One such computation of the complex index of refraction can be described by the equation:

$$N = n - jk,$$

where j is an imaginary number.

The signal (signature) library can be constructed from observed intensity/phase signatures and/or signatures generated by modeling and simulation. By way of illustration, when exposed to a first incident light of known intensity, wavelength and phase, a first feature on a wafer can generate a first phase/intensity signature. Similarly, when exposed to the first incident light of known intensity, wavelength and phase, a second feature on a wafer can generate a second phase/intensity signature. For example, a line of a first width may generate a first signature while a line of a second width may generate a second signature. Observed signatures can be combined with simulated and modeled signatures to form the signal (signature) library. Simulation and modeling can be employed to produce signatures against which measured phase/intensity signatures can be matched. In one exemplary aspect of the present invention, simulation, modeling and observed signatures are stored in a signal (signature) library containing over three hundred thousand phase/intensity signatures. Thus, when the phase/intensity signals are received from scatterometry detecting components, the phase/intensity signals can be pattern matched, for example, to the library of signals to determine whether the signals correspond to a stored signature.

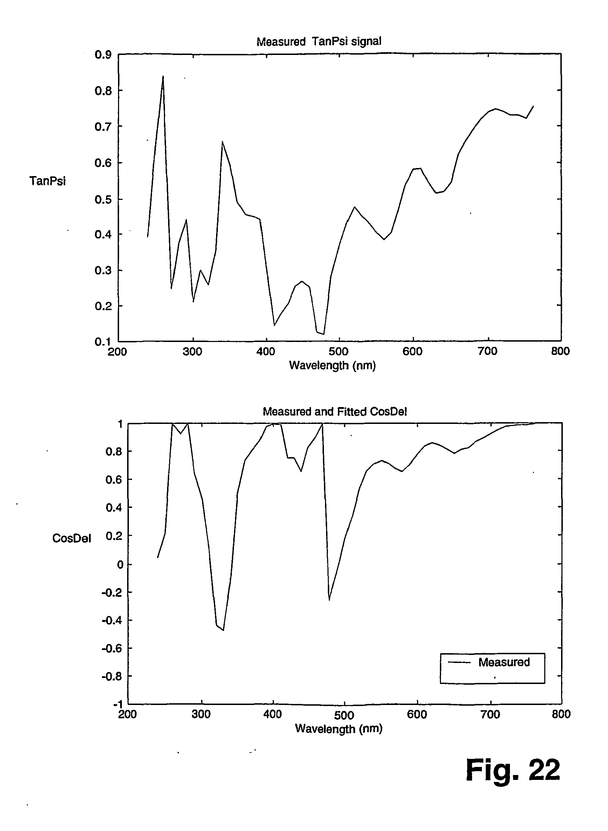

To illustrate the principles described above, reference is now made to Figs. 17 through 22. Referring initially to Fig. 17, an incident light 902 is directed at a surface 900, upon which one or more features 906 may exist. The incident light 902 is reflected as reflected light 904. The properties of the surface 900, including but not limited to, thickness, uniformity, planarity, chemical composition and the presence of features, can affect the reflected light 904. The features 906 are raised upon the surface 900. The phase and intensity of the reflected light 904 can be measured and plotted, as shown, for example, in Fig. 22. The phase 960 of the reflected light 904 can be plotted, as can the intensity 962 of the reflected light 904. Such plots can be employed to compare measured signals with signatures stored in a signature library using techniques like pattern matching, for example.

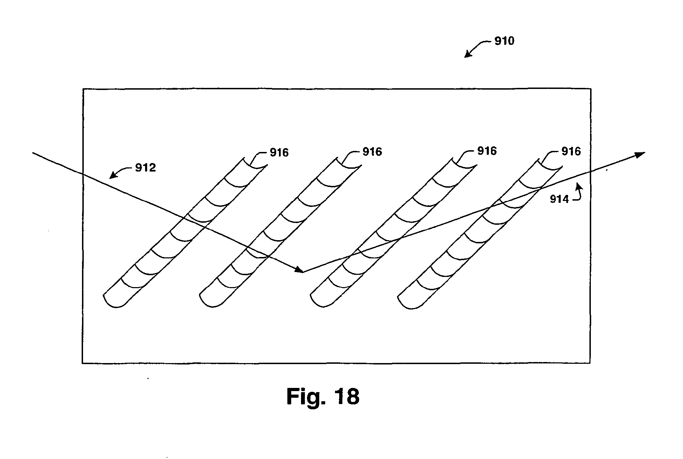

Referring now to Fig. 18, an incident light 912 is directed onto a surface 910 upon which one or more depressions 916 appear. The incident light 912 is reflected as reflected light 914. Like the one or more features 906 (Fig. 17) may affect an incident beam, so too may the one or more depressions 916 affect an incident beam. Thus, it is to be appreciated that scatterometry can be employed to measure features appearing on a surface, features appearing in a surface, and properties of a surface itself, regardless of features.

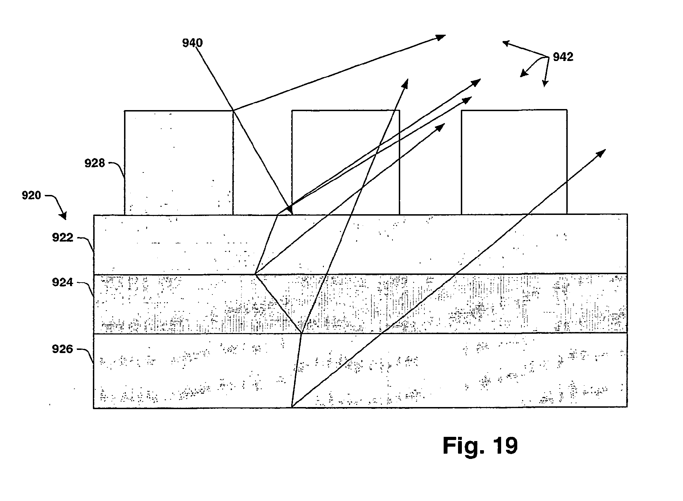

Turning now to Fig. 19, complex reflections and refractions of an incident light 940 are illustrated. The reflection and refraction of the incident light 940 can be affected by factors including, but not limited to, the presence of one or more features 928, and the composition of the substrate 920 upon which the features 928 reside. For example, properties of the substrate 920 including, but not limited to the thickness of a layer 922, the chemical properties of the layer 922, the opacity and/or reflectivity of the layer 922, the thickness of a layer 924, the chemical properties of the layer 924, the opacity and/or reflectivity of the layer 924, the thickness of a layer 926, the chemical properties of the layer 926, and the opacity and/or reflectivity of the layer 926 can affect the reflection and/or refraction of the incident light 940. Thus, a complex reflected and/or refracted light 942 may result from the incident light 940 interacting with the features 928, and/or the layers 922, 924 and 926. Although three layers 922, 924 and 926 are illustrated in Fig. 19, it is to be appreciated that a substrate can be formed of a greater or lesser number of such layers.

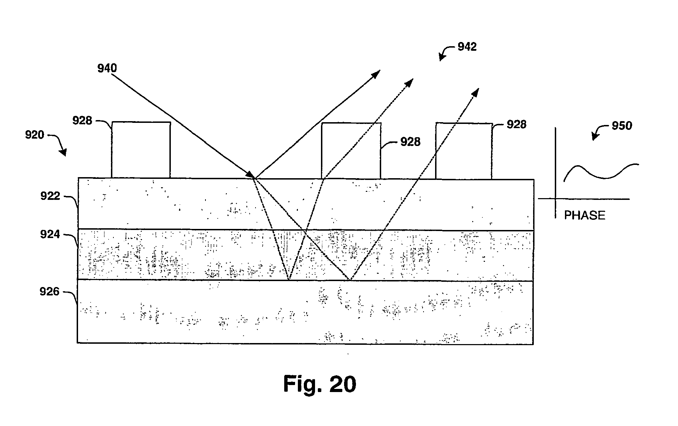

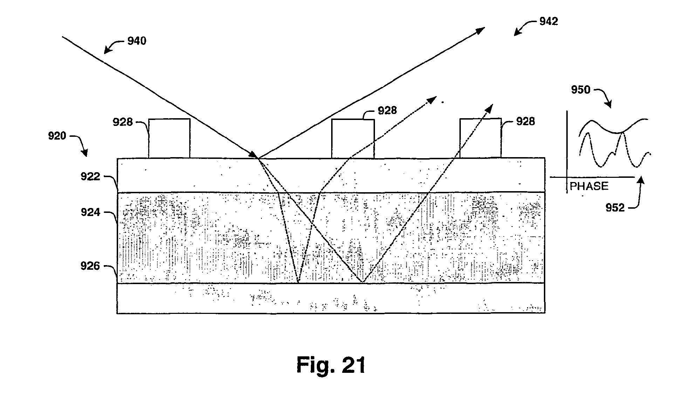

Turning now to Fig. 20, one of the properties from Fig. 19 is illustrated further. The substrate 920 can be formed of one or more layers 922, 924 and 926. The phase 950 of the reflected and/or refracted light 942 can depend, at least in part, on the thickness of a layer, for example, the layer 924. Thus, in Fig. 21, the phase 952 of the reflected light 942 differs from the phase 950 due, at least in part, to the different thickness of the layer 924 in Fig. 21.

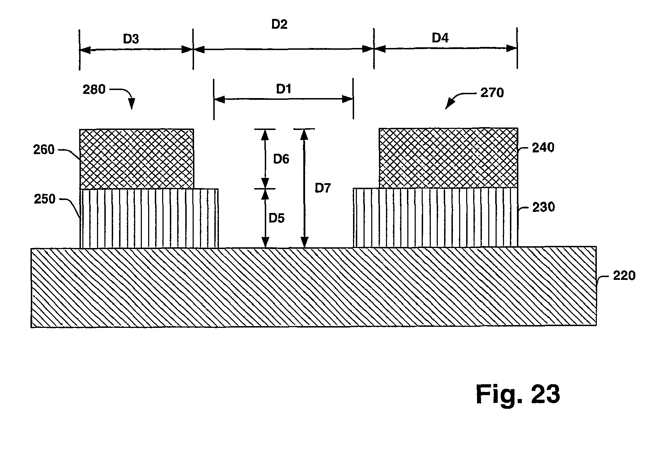

Turning now to Fig. 23, which is similar to Fig. 2, the measurements that may affect signatures generated by a scatterometry system associated with monitoring and/or controlling a dual damascene process are illustrated. Controlling such measurements (*e.g.*, width, depth, diameter, thickness) can be important to reliable and efficient operation of an integrated circuit.

A wafer 220 is illustrated with two features 270 and 280, between which there is a gap. The gap may have a depth of distance D7, where the depth D7 includes the depth D5 and the depth D6. Conventionally, controlling the depths D5 and/or D6, and thus the depth D7, may have required an etch-stop layer, to prevent the depth D7 from becoming too large. But including an etch-stop layer complicates, and thus makes more expensive, the fabrication of integrated circuits employing such etch-stop layers. Also conventionally, controlling the depths D5 and/or D6, and thus the depth D7 may have relied on pre-computed etch times. But such pre-computed etch times rely on indirect observation and do not account for wafer-to-wafer and/or feature-to-feature variations. Thus, the present invention employs scatterometry techniques to monitor the depths D5, D6 and D7, and to control the etch process(es) employed to create gaps with such depths.

While the depths D5, D6 and D7 are being monitored and controlled, horizontal distances may also be monitored, with such monitoring contributing to the control of the dual damascene process. Thus, the wafer 220 is illustrated with two features 270 and 280. The feature 270 is illustrated with an oxide layer 230 and a hardened photoresist layer 240. Similarly, the feature 280 is illustrated with an oxide layer 250 and a hardened photoresist layer 260. While the oxide layers 250 and 230 are separated by a distance D1, this distance may, for example, be too small for reliable operation of the integrated circuit being fabricated on the wafer 220. A desired critical dimension for the distance between the oxide layer 250 and the oxide layer 230 may be the distance D2. For example, a gap of size D2 may be required to facilitate fabricating a connecting line. Lithography sufficient to harden the photoresist layer 260 and the photoresist layer 270 may have been achieved in earlier fabrication steps, but such precise lithography may go to waste if precise etching of the features 270 and 280 can not be achieved. For example, sophisticated lithography may have produced the hardened photoresist 260 with a desired width of D3. Similarly, sophisticated lithography may have produced the hardened photoresist layer 240 with a desired width of D4, which should suffice to facilitate etching the oxide layers 250 and 230 if precise etching control is possible. But if precise etching control is not possible, then the distance D1 may be maintained, and reliable operation may not be achieved and/or the connecting line may not be able to be created.

Thus, the present invention facilitates generating information concerning measurements (*e.g.*, the distances D1, D2, D3, D4, D5, D6 and D7) and the resulting topographies of layers. Scatterometry-based real time control of the features 270 and 280, and thus the gap between the features 270 and 280, which may be employed for an interconnecting line, can be employed to control an etch process associated with a dual damascene process, and to determine the desirability of adaptations to one or more etch parameters (*e.g.*, temperature, formula, angle, direction, pressure). Such information, generated, at least in part, in response to *in situ* reflected light being analyzed by scatterometry techniques can be employed to generate process history data that can be employed to adapt future etch processes that are characterized by machine learning techniques that have access to such history data, thus providing advantages over conventional systems. For example, one or more signatures associated with the wafer 220 and/or the features 270 and 280 can be generated. At a first point in time T10, a signature S10 may be generated that indicates that desired critical dimensions have not been achieved. Thus, an etching process may be adapted in an attempt to achieve the desired critical dimension. Then, at a second point in time T11, a signature S11 may be generated that indicates that although the desired critical dimensions have still not been achieved, that progress toward the desired critical dimensions have occurred. The etching process may then be continued until a later point in time T12, when a signature S12 indicates that the desired critical dimensions have been achieved. But the signature S11 may have indicated that the adaptation to the etching process produced a movement away from desired critical dimensions, and thus the etch process may have been terminated, and the wafer marked for discard, for example.

Prior Art Figures 24-30 illustrate one conventional method of dual damascene processing that employs an etch-stop layer. The present invention facilitates performing an analogous dual damascene process (illustrated in Figs. 31-37) where the etch-stop layer is not required due to etch monitoring and controlling provided by a scatterometry based system. With regard to the description of the embodiment of Prior Art Figures 24-30, the term substrate includes not only a semiconductor substrate, such as semiconductor substrate 10, but also any and all layers and structures fabricated over the semiconductor substrate up to the point of processing under discussion.

Prior Art Figures 24-30 illustrate a method in connection with forming interconnections that make electrical contact to a metal structure 12 within a semiconductor substrate 10, where the method includes an etch-stop layer 13. However, the method of Prior Art Figures 24-30 may be used to form interconnects for other purposes. For example, the method of Prior Art Figures 24-30 may be adapted to making electrical contacts to various device structures, active elements and passive elements including polysilicon gates, wordlines, source regions, drain regions, bit lines, bases, emitters, collectors, conductive lines, conductive plugs, diffusion regions, etc. The method of Prior Art Figures 24-30 may be used with any suitable semiconductor technology including but not limited to NMOS, PMOS, CMOS, BiCMOS, bipolar, multi-chip modules (MCM) and III-IV semiconductors.

Referring to Prior Art Figure 24, a semiconductor substrate 10 having a metal structure 12 is provided. Semiconductor substrate 10 may include any suitable semiconductor material, for example, a monocrystalline silicon substrate. Metal structure 12 may be any structure to which an electrical contact is desired, for example, a copper line. An insulation material layer 13, such as silicon nitride, is formed over the substrate 10. The insulation material layer 13 may act as an etch-stop layer. The present invention facilitates mitigating problems that the etch-stop layer is designed to mitigate, and thus, the present invention facilitates performing a dual damascene process without the etch-stop layer 13. The insulation material layer 13 may include one or more of silicon dioxide, silicon oxynitride, boronitride, silicon boronitride and silicon carbide, for example. The insulation material layer 13 may be formed to any suitable thickness using any suitable technique, for instance, using chemical vapor deposition (CVD) techniques. CVD techniques include low pressure chemical vapor deposition (LPCVD) or plasma enhanced chemical vapor deposition (PECVD). The insulation material layer 13 subsequently serves as an etch stop layer for the later described low K material layers, as well as a barrier layer for the metal structure 12. A low k material layer 14, such as BCB, is formed over the insulation material 13. The low k material layer 14 may alternatively include one or more of polyimides, fluorinated polyimides, polysilsequioxane, parlene F, parlene N, amorphous polytetrafluoroethylene and Flare™ from AlliedSignal, for example.

It is to be appreciated that although Prior Art Figures 24-30 describe a wafer with several specific layers, that the dual damascene process described in Prior Art Figures 24-30 may be employed with other combinations of layers, and thus, the present invention is not limited to layer configurations described in connection with Prior Art Figures 24-30.

A hard mask layer 16, such as a layer of silicon dioxide, is deposited over the low k material layer 14 using suitable techniques, such as CVD techniques. The hard mask layer 16 may alternatively include one or more of silicon nitride, silicon oxynitride, boronitride, silicon boronitride and silicon carbide. A photoresist layer 18 is deposited over the hard mask layer 16.

Referring to Prior Art Figure 25, the photoresist layer 18 and hard mask layer 16 are patterned to define a preliminary contact opening 19 over at least a portion of a device structure, active element or passive element, or the metal structure 12 in this instance. Any suitable patterning technique may be used to define the preliminary contact opening 19 in the photoresist layer 18 and hard mask layer 16. For example, standard photolithographic techniques may be used. In particular, the photoresist layer 18 is exposed to radiation and developed to provide a patterned photoresist. The patterned photoresist is formed using electromagnetic radiation having a relatively small wavelength (for example, less than 365 nm). Either the exposed or unexposed portions of the photoresist layer 18 are removed or developed to provide the patterned photoresist exposing a corresponding portion of the hard mask layer 16 in preliminary contact opening 19.

The exposed portions of the hard mask layer 16 are etched anisotropically to further form preliminary contact opening 16 exposing at least a portion of the low k material layer 14. The patterned photoresist layer 18 may then be stripped from the substrate, and the substrate may be optionally cleaned to remove residue from preliminary contact opening 19.

Preliminary contact opening 19 may be formed to have any desired cross-section, width or diameter, primarily depending upon the wavelength of radiation employed. The preliminary contact openings 19 serve to define subsequently formed contact holes. Conventionally, controlling such cross-section, width and/or diameter may involve indirect monitoring and/or control (*e.g.*, timed etches, analyzing reacted gasses, etc.), which do not provide as precise a control as is possible with the scatterometry based system described herein.

Referring to Prior Art Figure 26, a second low k material layer 20 may be formed to any suitable thickness using any suitable technique over the substrate, including over the hard mask layer 16 and the exposed portion of the low k material layer 14 in the preliminary contact opening 19.

A second hard mask layer 22, such as a layer of silicon dioxide, is deposited over the second low k material layer 20 using suitable techniques, such as CVD techniques. The second hard mask layer 22 may alternatively include one or more of silicon nitride, silicon oxynitride, boronitride, silicon boronitride and silicon carbide.

A second photoresist layer 24 is deposited over the second hard mask layer 22. The second photoresist layer 24 and the second hard mask layer 22 subsequently serve as a trench mask for forming a trench over a plurality of contact holes.

Referring to Prior Art Figure 27, the second photoresist layer 24 and second hard mask layer 22 are patterned to define a trench mask over at least a portion of a device structure, active element or passive element, or the metal structure 12 in this instance. Any suitable patterning technique may be used to define the trench mask in the second photoresist layer 24 and second hard mask layer 22. For example, standard photolithographic techniques may be used. In particular, the second photoresist layer 24 is exposed to radiation and developed to provide a patterned photoresist. The patterned photoresist is formed using electromagnetic radiation having a relatively small wavelength (for example, less than 365 nm). Either the exposed or unexposed portions of the second photoresist layer 24 are removed or developed to provide the patterned photoresist exposing a corresponding portion of the second hard mask layer 22 in the trench region.

The exposed portions of the second hard mask layer 22 are etched anisotropically to further form the trench exposing at least a portion of the second low k material layer 20. Conventionally, controlling such etching may include employing timed etches and/or analyzing reacted gasses. Such indirect methods do not provide as precise a control as the scatterometry based system described herein. The trench may be formed to have any desired cross-section, width or diameter. The width of the trench may depend on the resistivity of the conductive material used for creating an interconnect within the trench. The width of the trench is typically larger than the width of previously described preliminary contact opening 19.

Referring to Prior Art Figure 28, exposed portions of the second low k material layer 20, low k material layer 14 and insulation material layer 13 are removed in any suitable manner to define an opening 26 comprised of a trench or interconnect channel over at least one contact hole formed over metal structure 12. Any suitable etch technique may be used to etch second low k material layer 20, low k material layer 14 and insulation material layer 13. Preferably, a selective etch technique may be used to etch the material of low k material layers 20 and 14 and at a relatively greater rate as compared to the rate that the material of the insulation material layer 13, second photoresist layer 24, and/or second hard mask layer 22 are etched. In other words, the insulation material layer 13 serves as an etch-stop layer when etching low k material layers 20 and 14. Including such an etch-stop layer increases the complexity, and thus the cost, of the wafer upon which the integrated circuit is formed. Portions of the low k material layer 14 and second low k material layer 20 are typically etched in an anisotropic manner using an oxygen containing gas exposing a portion of the insulation material layer 13.

The exposed portion of the insulation material layer 13 is etched in an anisotropic manner using a suitable gas mixture, primarily depending upon the composition of the insulation material layer 13 exposing at least a portion of the metal structure 12. The second photoresist layer 24 may then be stripped from the substrate, and the substrate may be optionally cleaned to remove residue from the opening 26. However, since the second photoresist layer 24 has a thickness about 2,000 □ or less, the second photoresist layer 24 is typically removed during removal of portions of the low k material layers 14 and 20 where an oxygen containing gas is used as an etchant. In a preferred embodiment, therefore, the insulation material layer 13 and the second hard mask layer 22 contain different materials to afford etch selectivity.

Referring to Prior Art Figure 29, a suitable conductive material or materials is formed or deposited over the substrate, including filling the opening 26 and over the second hard mask layer 22. For example, an optional barrier layer 28 and a conductive layer 30 are deposited over the substrate. The optional barrier layer 28 may serve as a diffusion barrier preventing materials from the conductive layer 30 from diffusing into the low k material layer 14 and/or second low k material layer 20. The optional barrier layer 28 is formed over the substrate so that it covers the side walls and bottom in the opening 26. The barrier layer 28 may be formed using any suitable technique to a thickness sufficient to serve as a diffusion barrier for conductive layer 30. The barrier layer 28 is a conductive layer containing, for example, tantalum, tungsten, titanium, alloys, silicides, and/or nitrides thereof.

Referring to Prior Art Figure 30, conductive layer 30 is planarized to the surface of the barrier layer 28; that is, portions of the conductive layer 30 are removed from the top surface of barrier layer 28 above the second hard mask layer 22. Opening 26 remains substantially filled with the barrier layer 28 and conductive layer 30. Any suitable technique may be used to planarize the substrate and may depend, for instance, on the specific identity of the material used to make the conductive layer 30. In one embodiment, the substrate is planarized (a portion of the conductive layer is removed) using chemical mechanical polishing (CMP) techniques using a polishing solution or slurry depending upon the specific identity of the materials used for the conductive layer 30. As a result of CMP techniques, dishing may occur wherein the conductive layer 30 is removed to a level below the top surface of the barrier layer 28, and in some instances, to a level just below the top surface of the second hard mask layer 22.

The portion of the optional barrier layer 28, if employed, exposed over the second hard mask layer 22 is removed using CMP techniques or an etch gas mixture. After the portion of the barrier layer exposed over the second hard mask layer 22 is removed, the substrate may be cleaned using conventional techniques such as wet cleaning techniques. Removal of the exposed portion of the barrier layer serves to planarize the substrate while leaving undisturbed the portion of the barrier layer 28 surrounding conductive layer 30. If employed, the etch gas mixture has high etch selectivity for the barrier metal as compared to a hard mask material, such as silicon oxide, which may constitute the second hard mask layer 22 as well as other conductive metals such as copper or copper alloys, which may constitute the conductive layer 30. In this embodiment, the etch gas mixture provides a selective etch such that the conductive layer 30 serves as a mask in etching the barrier layer 28. The etch gas mixture etches in an isotropic manner whereby there is no or very little change in side wall profile of the conductive layer 30.

It is to be appreciated that Prior Art Figures 24-30 illustrate but one example dual damascene process, and that the present invention is not limited to improving the illustrated dual damascene process, but that the present invention can be employed to improve other dual damascene processes.

Turning now to Figs. 31 through 37, an example of the application and benefits of scatterometry as applied to a dual damascene process is provided. One of the advantages of present invention, removal of an etch-stop layer is particularly noted. It is to be appreciated that removing the etch-stop layer is not the only advantage of the present invention, and that other advantages (*e.g.*, more precise end point control, real time process control) are associated with the present invention.

Referring to Figure 31, a semiconductor substrate 10 having metal structure 12 is provided. Semiconductor substrate 10 may include any suitable semiconductor material, for example, a monocrystalline silicon substrate. Metal structure 12 may be any structure to which an electrical contact is desired, for example, a copper line. The present invention facilitates mitigating problems that the etch-stop layer is designed to prevent, and thus, the present invention facilitates performing a dual damascene process without an etch-stop layer (*e.g.*, insulation layer 13, Prior Art Figure 24). A low k material layer 14, such as BCB, is formed. Low k material layer 14 may be formed to any suitable thickness using any suitable technique that may depend, for instance, on the material or materials used. In the case of BCB, a spin on technique is useful.

It is to be appreciated that although Figures 31-37 describe a wafer with several specific layers, that the dual damascene process described in Figures 31-37 may be employed with other combinations of layers, and thus, the present invention is not limited to layer configurations described in connection with Figures 31-37.

A hard mask layer 16, such as a layer of silicon dioxide, is deposited over the low k material layer 14 using suitable techniques, such as CVD techniques. The hard mask layer 16 may alternatively include one or more of silicon nitride, silicon oxynitride, boronitride, silicon boronitride and silicon carbide. An photoresist layer 18 is deposited over the hard mask layer 16.

Referring to Figure 32, the photoresist layer 18 and hard mask layer 16 are patterned to define a preliminary contact opening 19 over at least a portion of a device structure, active element or passive element, or the metal structure 12 in this instance. Any suitable patterning technique may be used to define the preliminary contact opening 19 in the photoresist layer 18 and hard mask layer 16. For example, standard photolithographic techniques may be used. In particular, the photoresist layer 18 is exposed to radiation and developed to provide a patterned photoresist. The patterned photoresist is formed using electromagnetic radiation having a relatively small wavelength (for example, less than 365 nm). Either the exposed or unexposed portions of the photoresist layer 18 are removed or developed to provide the patterned photoresist exposing a corresponding portion of the hard mask layer 16 in preliminary contact opening 19.

The exposed portions of the hard mask layer 16 are etched anisotropically to further form preliminary contact opening 16 exposing at least a portion of the low k material layer 14. The progress of the anistropic etching can be monitored by the present invention, so that the anistropic etching will proceed until desired CDs (*e.g.*, depth, width, diameter, geometry) are achieved. Then, the present invention facilitates terminating the anistropic etch once real time information concerning desired CDs has been analyzed and thus more precise etching is achieved. The patterned photoresist layer 18 may then be stripped from the substrate, and the substrate may be optionally cleaned to remove residue from preliminary contact opening 19.

Preliminary contact opening 19 may be formed to have any desired cross-section, width or diameter, such as about 0.1 □m or less, including about 0.09 □m or less, about 0.075 □m or less and about 0.05 □m or less, primarily depending upon the wavelength of radiation employed. The preliminary contact openings 19 serve to define subsequently formed contact holes. Since the present invention facilitates forming the preliminary contact opening 19 more precisely, subsequently formed contact holes may also be more precisely formed, providing advantages over conventional systems.

Referring to Figure 33, a second low k material layer 20 may be formed to any suitable thickness using any suitable technique over the substrate, including over the hard mask layer 16 and the exposed portion of the low k material layer 14 in the preliminary contact opening 19.

A second hard mask layer 22, such as a layer of silicon dioxide, is deposited over the second low k material layer 20 using suitable techniques, such as CVD techniques. The second hard mask layer 22 may alternatively include one or more of silicon nitride, silicon oxynitride, boronitride, silicon boronitride and silicon carbide.

A second photoresist layer 24 is deposited over the second hard mask layer 22. The second photoresist layer 24 and the second hard mask layer 22 subsequently serve as a trench mask for forming a trench over a plurality of contact holes.

Referring to Figure 34, the second photoresist layer 24 and second hard mask layer 22 are patterned to define a trench mask over at least a portion of a device structure, active element or passive element, or the metal structure 12 in this instance. Any suitable patterning technique may be used to define the trench mask in the second photoresist layer 24 and second hard mask layer 22. For example, standard photolithographic techniques may be used. In particular, the second photoresist layer 24 is exposed to radiation and developed to provide a patterned photoresist. The patterned photoresist is formed using electromagnetic radiation having a relatively small wavelength (for example, less than 365 nm). Either the exposed or unexposed portions of the second photoresist layer 24 are removed or developed to provide the patterned photoresist exposing a corresponding portion of the second hard mask layer 22 in the trench region.

The exposed portions of the second hard mask layer 22 are etched anisotropically to further form the trench exposing at least a portion of the second low k material layer 20. The trench may be formed to have any desired cross-section, width or diameter, such as about 0.25 □m, about 0.18 □m, about 0.15 □m, about 0.13, about 0.1□m, about 0.075 and/or about 0.05 □m. The width of the trench may depend on the resistivity of the conductive material used for creating an interconnect within the trench. The width of the trench is typically larger than the width of previously described preliminary contact opening 19. The present invention facilitates monitoring and/or controlling the etching of the trench and thus facilitates more precisely forming the trench. Thus, the cross-section, width and/or diameter may be more precisely controlled, leading to improvements in chip quality and/or reliability.

Referring to Figure 35, exposed portions of the second low k material layer 20 and low k material layer 14 are removed in any suitable manner to define an opening 26 comprised of a trench or interconnect channel over at least one contact hole formed over metal structure 12. Any suitable etch technique may be used to etch second low k material layer 20 and low k material layer 14. Conventionally, an etch-stop layer (*e.g.*, layer 13, Prior Art Figure 28) would be employed at this point in the dual damascene process. But the present invention facilitates etching the second low k material layer 20 and the low k material layer 14 without such an etch-stop layer. Thus, with the removal of the etch-stop layer, a simpler architecture for the integrated circuit is achieved. The second photoresist layer 24 may then be stripped from the substrate, and the substrate may be optionally cleaned to remove residue from the opening 26.

Referring to Figures 36 and 37, processing substantially similar to that of Prior Art Figures 29 and 30 is undertaken to complete the portion of the dual damascene process. Thus, through the use of scatterometry based monitoring and control of the etching in the dual damascene process illustrated in Figures 31-37, a simpler wafer architecture and more precise feature forming are achieved. It is to be appreciated that Figures 31-37 illustrate but one example dual damascene process, and that the present invention is not limited to improving the illustrated dual damascene process, but that the present invention can be employed to improve other, non-illustrated dual damascene processes.

Thus, scatterometry is a technique that can be employed to extract information about a surface upon which an incident light has been directed. The information can be extracted by analyzing phase and/or intensity signals of a complex reflected and/or diffracted light. The intensity and/or the phase of the reflected and/or diffracted light will change based on properties of the surface upon which the light is directed, resulting in substantially unique signatures that can be analyzed to determine one or more properties of the surface upon which the incident light was directed. Using scatterometry in the present invention facilitates a relatively non-invasive approach to characterizing an etch process by producing, for example, real time profile images.

Described above are preferred embodiments of the present invention. It is, of course, not possible to describe every conceivable combination of components or methodologies for purposes of describing the present invention, but one of ordinary skill in the art will recognize that many further combinations and permutations of the present invention are possible. Accordingly, the present invention is intended to embrace all such alterations, modifications and variations that fall within the spirit and scope of the appended claims.

## Claims

**1.** A method for characterizing an etch process in real time, on a wafer (1010) that does not contain an etch step layer, the method comprising:

providing a wafer (1010);
logically partitioning the wafer (1010) into one or more portions;
fabricating one or more gratings to be etched on the wafer (1010); and
etching the wafer (1010);

wherein simultaneously with said etching, the method further comprises:

directing an incident light onto at least one of the one or more gratings; and
collecting a reflected light reflected from the at least one grating; and
processing the reflected light in a scatterometry system and computing one or more suggested adjustments to the etch process for providing as feedback during said etching for regulating the etching.

**2.** A method as claimed in claim 1, where computing the one or more suggested adjustments to the etch process being **characterized** is based, at least in part, on comparing the one or more etching results to scatterometry signatures associated with one or more stored etching results.

**3.** A method as claimed in claim 1, wherein:

said step of logically partitioning comprises logically partitioning a wafer into one or more grid blocks;
said step of etching comprises etching the wafer with one or more etching components, where the one or more etching components are operable to etch at least one of the one or more grid blocks;
said step of directing an incident light comprises, while the etching is in progress, directing an incident light on at least one of the one or more grid blocks;
said step of collecting comprising, while the etching is in progress, collecting a reflected light from the one or more grid blocks, the reflected light originating as the incident light; and
said step of analyzing comprising, while the etching is in progress, monitoring the etch process in at least one of the one or more grid blocks by analyzing the reflected light,

wherein monitoring the etch process comprises:

generating one or more scatterometry signatures from the reflected light; and
comparing the one or more generated scatterometry signatures to one or more stored scatterometry signatures.

**4.** A system (1000) for characterizing an etch process in real time, the system for etching a wafer that does not contain an etch stop layer, and comprising:

at least one etching component (1030) operative to etch at least one portion of the wafer (1010);
an etch component driving system (1060) operably connected to the at least one etching component (1030), the etch component driving system (1060) adapted to drive the at least one etching component (1030);
a system for directing light toward one or more gratings (1015) and/or features located on at least one portion of the wafer (1010);
an etch monitoring system (1070) operable to measure one or more etching results from light reflected from the one or more gratings (1015) and/or features during etching of at least one portion of the wafer (1010) and including a scatterometry system (1075) for processing the reflected light; and
a processor (1040) operatively coupled to the etch monitoring system (1070) and the etch component driving system (1060), wherein the processor (1040) receives an etching result data from the etch monitoring system (1070) and analyzes the etching result data by comparing the etching result data to stored etching result data;

wherein the processor (1040) is adapted to provide feedback to the etch component driving system (1060) during said etching to regulate the etching of the wafer (1010).

**5.** A system as claimed in claim 4, the processor (1040) being operatively coupled to the scatterometry system (1075), the processor (1040) analyzing data received from the scatterometry system (1075) and producing an analyzed data.

**6.** A system as claimed in claim 4, the processor (1040) logically mapping the wafer (1010) into one or more grid blocks and making a determination of the acceptability of etching values in the one or more grid blocks, wherein the processor (1040) determines the existence of unacceptable etching values for at least a portion of the wafer (1010) based on comparing one or more measured etching values to one or more stored etching values, and the processor (1040) computes one or more suggested adjustments to the etching process being **characterized**.

**7.** A system as claimed in claim 4, the system for characterizing a dual damascene process, wherein:

said at least one etching component (1030) is operative to etch a dual damascene opening in at least one portion of a wafer (1010);
said etch component driving system (1060) is operably connected to the at least one etching component (1030), the etch component driving system (1060) adapted to drive the at least one etching component (1030);
said system is for directing light toward one or more gratings (1015) and/or dual damascene openings located on at least one portion of the wafer (1010);
said etch monitoring system (1070) is operable to measure one or more etching results from light reflected from the one or more gratings (1015) and/or dual damascene openings; and said processor (1040) is operatively coupled to the etch monitoring system (1070) and the etch component driving system (1060), wherein the processor (1040) receives an etching result data from the monitoring system (1070) and analyses the etching result data by comparing the etching result data to stored etching result data.

**8.** A system as claimed in claim 7, the etch monitoring system (1070) further including a scatterometry system (1075) for processing the light reflected from the one or more gratings (1015), the processor (1040) being operatively coupled to the scatterometry system (1075), the processor (1040) analyzing data received from the scatterometry system (1075) and producing an analyzed data.

**Patentansprüche**

**1.** Verfahren zum Bewerten eines Ätzprozesses in Echtzeit auf einer Scheibe (1010), die keine Ätzstoppschicht aufweist, wobei das Verfahren umfasst:

Bereitstellen einer Scheibe (1010);
logisches Unterteilen der Scheibe (1010) in einen oder mehrere Bereiche;
Erzeugen eines oder mehrerer Gitter, die auf der Scheibe (1010) zu ätzen sind; und
Ätzen der Scheibe (1010);

wobei gleichzeitig mit dem Ätzen das Verfahren ferner umfasst:

Beleuchten mindestens eines des einen oder der mehreren Gitter mit einfallendem Licht; und
Sammeln von reflektiertem Licht, das von dem mindestens einen Gitter reflektiert wird; und
Verarbeiten des reflektierten Lichts in einem Streumesssystem und Berechnen einer oder mehrerer vorgeschlagener Einstellungen für den Ätzprozess zur Bereitstellung als Rückkopplung während des Ätzens, um das Ätzen zu regeln.

**2.** Verfahren nach Anspruch 1, wobei Berechnen der einen oder mehreren vorgeschlagenen Einstellungen für den zu bewertenden Ätzprozess zumindest teilweise beruht auf: Vergleichen des einen oder der mehreren Ätzergebnisse mit Streumesssignaturen, die mit einem oder mehreren gespeicherten Messergebnissen verknüpft sind.

**3.** Verfahren nach Anspruch 1, wobei:

der Schritt des logischen Unterteilens umfasst: logisches Unterteilen einer Scheibe in einen oder mehrere Rasterfeldblöcke;
der Schritt des Ätzens umfasst: Ätzen der Scheibe mit einer oder mehreren Ätzkomponenten, wobei die eine oder die mehreren Ätzkomponenten geeignet sind, mindestens einen des einen oder der mehreren Rasterfeldblöcke zu ätzen;
der Schritt des Beleuchtens mit einfallendem Licht umfasst: Beleuchten mindestens eines des einen oder der mehreren Rasterfeldblöcke mit einfallendem Licht während der Ätzvorgang abläuft;
der Schritt des Sammelns umfasst: Sammeln von reflektiertem Licht aus dem einen oder den mehreren Rasterfeldblöcken während des Ätzens, wobei das reflektierte Licht von dem einfallenden Licht stammt; und
der Schritt des Analysierens umfasst: Überwachen des Ätzprozesses in mindestens einem des einen oder der mehreren Rasterfeldblöcke durch Analysieren des reflektierten Lichts, während der Ätzvorgang abläuft,

wobei Überwachen des Ätzprozesses umfasst:

Erzeugen einer oder mehrerer Streumesssignaturen aus dem reflektierten Licht; und
Vergleichen der einen oder der mehreren erzeugten Streumesssignaturen mit einer oder mehreren gespeicherten Streumesssignaturen.

**4.** System (1000) zum Bewerten eines Ätzprozesses in Echtzeit; wobei das System geeignet ist, eine Scheibe zu ätzen, die keine Ätzstoppschicht aufweist, und wobei das System umfasst:

mindestens eine Ätzkomponente (1030), die ausgebildet ist, mindestens einen Bereich der Scheibe (1010) zu ätzen;
ein Ätzkomponentenansteuersystem (1060), das mit der mindestens einen Ätzkomponente (1030) funktionsmäßig verbunden ist, wobei das Ätzkomponentenantriebssystem (1060) ausgebildet ist, die mindestens eine Ätzkomponente (1030) anzusteuern;
ein System zum Beleuchten eines oder mehrerer Gitter (1015) und/oder von Strukturelementen, die zumindest auf einem Teil der Scheibe (1010) angeordnet sind, mit Licht;
ein Ätzüberwachungssystem (1070) das ausgebildet ist, ein oder mehrere Ätzergebnisse mittels Licht zu messen, das von dem einen oder den mehreren Gittern (1015) und/oder den Strukturelementen während des Ätzens zumindest eines Bereichs der Scheibe (1010) reflektiert wird, und wobei das Ätzüberwachungssystem ein Streumesssystem (1075) zum Verarbeiten des reflektierten Lichts enthält; und
einen Prozessor (1040), der funktionsmäßig mit dem Ätzüberwachungssystem (1070) und dem Ätzkomponentenansteuersystem (1060) verbunden ist, wobei der Prozessor (1040) Ätzergebnisdaten von dem Überwachungssystem (1070) empfängt und die Ätzergebnisdaten durch Vergleichen der Ätzergebnisdaten mit gespeicherten Ätzergebnisdaten analysiert;

wobei der Prozessor (1040) ausgebildet ist, eine Rückkopplung dem Ätzkomponentenansteuersystem (1060) während des Ätzens zuzuleiten, um das Ätzen der Scheibe (1010) zu regeln.

**5.** System nach Anspruch 4, wobei der Prozessor (1040) funktionsmäßig mit dem Streumesssystem (1075) verbunden ist und wobei der Prozessor (1040) Daten, die von dem Streumesssystem (1075) empfangen werden, analysiert und analysierte Daten erzeugt.

**6.** System nach Anspruch 4, wobei der Prozessor (1040) die Scheibe (1010) logisch in einen oder mehrere Rasterfeldblöcke unterteilt und eine Bestimmung über die Akzeptabilität von Ätzwerten in dem einen oder den mehreren Rasterfeldblöcken vornimmt, wobei der Prozessor (1040) das Vorhandensein nicht akzeptabler Ätzwerte für zumindest einen Bereich der Scheibe (1010) auf der Grundlage eines Vergleichs eines oder mehrerer gemessener Ätzwerte mit einem oder mehreren gespeicherten Ätzwerten bestimmt, und wobei der Prozessor (1040) eine oder mehrere vorgeschlagene Einstellungen für den zu bewertenden Prozess berechnet.

**7.** System nach Anspruch 4, wobei das System zur Bewertung eines Dopppel-Damaszener-Prozesses ausgebildet ist, wobei:

die mindestens eine Ätzkomponente (1030) ausgebildet ist, eine Doppel-Damaszener-Öffnung in zumindest einen Bereich einer Scheibe (1010) zu ätzen;
das Ätzkomponentenansteuersystem (1060) funktionsmäßig mit der mindestens einen Ätzkomponente (1030) verbunden ist, wobei das Ätzkomponentenansteuersystem (1060) ausgebildet ist, die mindestens eine Ätzkomponente (1030) anzusteuern;
das System zum Beleuchten eines oder mehrerer Gitter (1015) und/oder von Doppel-Damaszener-Öffnungen, die zumindest auf einem Bereich der Scheibe (1010) angeordnet sind, mit einfallendem Licht ausgebildet ist;
das Ätzüberwachungssystem (1070) ausgebildet ist, ein oder mehrere Ätzergebnisse mittels von dem einen oder den mehreren Gittern (1015) und/oder den Doppel-Damaszener-Öffnungen reflektierten Lichts zu messen; und
der Prozessor (1040) funktionsmäßig mit dem Ätzüberwachungssystem (1070) und dem Ätzkomponentenansteuersystem (1060) verbunden ist, wobei der Prozessor (1040) Ätzergebnisdaten von dem Überwachungssystem (1070) empfängt und die Ätzergebnisdaten durch Vergleichen der Ätzergebnisdaten mit gespeicherten Ätzergebnisdaten analysiert.

**8.** System nach Anspruch 7, wobei das Ätzüberwachungssystem (1070) ferner ein Streumesssystem (1075) zum Verarbeiten des Lichts enthält, das von dem einen oder den mehreren Gittern (1015) reflektiert wird, wobei der Prozessor (1040) funktionsmäßig mit dem Streumesssystem (1075) verbunden ist und der Prozessor (1040) von dem Streumesssystem (1075) empfangene Daten analysiert und analysierte Daten erzeugt.

## Revendications

**1.** Procédé de caractérisation d'un processus de gravure en temps réel, sur une plaquette (1010) qui ne contient pas de couche d'arrêt de la gravure, le procédé comprenant les étapes consistant à :

fournir une plaquette (1010) ;
compartimenter de façon logique la plaquette (1010) en une ou en plusieurs portion(s) ;
fabriquer une ou plusieurs (grille(s) à graver sur la plaquette (1010) ; et
graver la plaquette (1010) ;

dans lequel, simultanément à ladite gravure, le procédé consiste, de plus, à :

traiter une lumière incidente sur l'une au moins d'une ou de plusieurs grilles ; et
collecter une lumière réfléchie à partir d'au moins une grille ; et
diriger la lumière réfléchie dans un système de diffusométrie et calculer un ou plusieurs réglage (s) suggéré(s) pour le processus de gravure en vue de fournir à titre de réaction pendant ladite gravure une régulation de ladite gravure.

**2.** Procédé selon la revendication 1, dans lequel le calcul de l'un ou de plusieurs des réglages suggérés pour le processus de gravure en cours de caractérisation est fondé, au moins en partie, sur la comparaison de l'un ou de plusieurs des résultats de gravure avec des signatures de diffusométrie associées à l'un ou à plusieurs résultats de gravure enregistrés.

**3.** Procédé selon la revendication 1, dans lequel :

ladite étape de compartimentage logique consiste à compartimenter de façon logique une plaquette en un ou en plusieurs bloc(s) de grille ;
ladite étape de gravure consiste à graver la plaquette avec un ou plusieurs composant(s) de gravure, dans laquelle le ou les composants de gravure est (sont) opérationnel(s) pour graver au moins l'un d'un ou de plusieurs bloc(s) de grille ;
ladite étape consistant à diriger une lumière incidente consiste, tandis que la gravure est en cours, à diriger une lumière incidente sur au moins un du ou des blocs de grille ;
ladite étape de collecte consistant, alors que la gravure est en cours, à collecter une lumière réfléchie à partir de l'un ou de plusieurs bloc(s) de grille, la lumière réfléchie provenant de la lumière incidente ; et
ladite étape d'analyse consistant, alors que la gravure est en cours, à contrôler le processus de gravure dans au moins un d'un ou de plusieurs bloc(s) de grille en analysant la lumière réfléchie,

dans lequel le contrôle du processus de gravure consiste à :

générer une ou plusieurs signature(s) de diffusométrie à partir de la lumière réfléchie ; et
comparer une ou plusieurs des signature(s) de diffusométrie générée(s) à une ou à plusieurs signature(s) de diffusométrie enregistrée(s).

**4.** Système (1000) permettant de caractériser un processus de gravure en temps réel, le système permettant de graver une plaquette qui ne contient pas de couche d'arrêt de la gravure, et comprenant :

au moins un composant de gravure (1030) actif pour graver au moins une partie de la plaquette (1010) ;
un système de commande de composant de gravure (1060) connecté de façon active au (aux) composant(s) de gravure (1030), le système de commande de composant de gravure (1060) étant adapté pour commander le, au moins un, composant de gravure (1030) ;
un système pour diriger une lumière vers une ou vers plusieurs grille(s) (1015) et/ou des motifs placés sur au moins une partie de la plaquette (1010) ;
un système de contrôle de gravure (1070) étant opérationnel pour mesurer un ou plusieurs résultat(s) de gravure à partir de la lumière réfléchie provenant de la grille ou de plusieurs grilles (1015) et/ou de caractéristiques pendant la gravure d'au moins une partie de la plaquette (1010) et incluant un système de diffusométrie (1075) pour traiter la lumière réfléchie ; et
un processeur (1040) couplé fonctionnellement au système de contrôle de gravure (1070) et au système de commande de composant de gravure (1060), dans lequel le processeur (1040) reçoit des données de résultat de gravure venant du système de contrôle de gravure (1070) et analyse les données de résultat de gravure en comparant les données de résultat de gravure aux données de résultat de gravure enregistrées ;

dans lequel le processeur (1040) est adapté pour fournir une réaction au système de commande du composant de gravure (1060) pendant ladite gravure afin de réguler la gravure de la plaquette (1010).

**5.** Système selon la revendication 4, le processeur (1040) étant couplé fonctionnellement au système de diffusométrie (1075), le processeur (1040) analysant les données reçues à partir du système de diffusométrie (1075) et produisant des données analysées.

**6.** Système selon la revendication 4, le processeur (1040) configurant de façon logique la plaquette (1010) en un ou en plusieurs bloc(s) de grille et établissant une détermination de l'acceptabilité des valeurs de gravure dans un ou plusieurs bloc(s) de grille, dans lequel le processeur (1040) détermine l'existence de valeurs de gravure inacceptables pour au moins une partie de la plaquette (1010) sur la base de la comparaison d'une ou de plusieurs valeur(s) de gravure mesurée(s) à une ou à plusieurs valeur(s) de gravure enregistrée(s), et le processeur (1040) calcule un ou plusieurs réglage(s) suggéré(s) pour le processus de gravure en cours de caractérisation.

**7.** Système selon la revendication 4, le système permettant de caractériser un double processus damascène, dans lequel :

ledit au moins un composant de gravure (1030) est actif pour graver une ouverture damascène double dans une partie au moins d'une plaquette (1010) ;
ledit système de commande de composant de gravure (1060) est connecté fonctionnellement à au moins un composant de gravure (1030), le système de commande de composant de gravure (1060) étant adapté pour commander le, au moins un, composant de gravure (1030) ;
ledit système sert à diriger une lumière vers une ou plusieurs grille(s) (1015) et/ou des ouvertures damascènes doubles situées sur au moins une partie de la plaquette (1010) ;
ledit système de contrôle de gravure (1070) est opérationnel pour mesurer un ou plusieurs résultat(s) de gravure à partir de la lumière réfléchie provenant d'une ou de plusieurs grille(s) (1015) et/ou des ouvertures damascènes doubles ; et
ledit processeur (1040) est couplé fonctionnellement au système de contrôle de gravure (1070) et au système de commande du composant de gravure (1060), dans lequel le processeur (1040) reçoit des données de résultat de gravure venant du système de contrôle (1070) et analyse les données de résultat de gravure en comparant les données de résultat de gravure aux données de résultat de gravure enregistrées.

**8.** Système selon la revendication 7, le système de contrôle de gravure (1070) comportant, de plus, un système de diffusométrie (1075) pour traiter la lumière réfléchie provenant de la ou de plusieurs grille(s) (1015), le processeur (1040) étant couplé fonctionnellement au système de diffusométrie (1075), le processeur (1040) analysant des données reçues à partir du système de diffusométrie (1075) et produisant des données analysées.

SIGNATURE
DATA
STORE
140
100
ETCH PROCESS CHARACTERIZING SYSTEM
110
ETCH
COMPONENTS
120
150
160
130

Fig. 1

ETCH PROCESS CHARACTERIZING SYSTEM
200
ETCH COMPONENTS
210
270
280
290
295
D1
260
250
240
230
220

Fig. 2

D3
D2
D4
D1
380
370
360
340
350
330
320
D6
D5
D7

Fig. 3

ETCH PROCESS CHARACTERIZING SYSTEM
400
450
DX
DY
470
430

Fig. 4

A
500
WAFER
B
502
OXIDE
500
WAFER
C
504
RESIST
502
OXIDE
500
WAFER

Fig. 5

508
LIGHT
SOURCE
D
506
RETICLE
504
RESIST
502
OXIDE
500
WAFER
E
504
RESIST
502
OXIDE
500
WAFER

Fig. 6

F
1060
1030
1030
ETCHING
COMPONENT DRIVING
SYSTEM
504
RESIST
502
OXIDE
500
WAFER
G
716
718
714
710
712
502
OXIDE
500
WAFER

Fig. 7

802
810
806
808
804
800

Fig. 8

902
904
906
900

Fig. 9

1040
PROCESSOR
1050
MEMORY
1000
POWER SUPPLY
1080
1075
SCATTEROMETERY SYSTEM
1070
ETCHING PROCESS CHARACTERIZING SYSTEM
1060
ETCH COMPONENT DRIVING SYSTEM
LIGHT SOURCE
1090
1020
1030
1030
1030
1030
1025
1015
1015
1015
1010
Fig. 10

1000
1040
PROCESSOR
1070
ETCHING PROCESS CHARACTERIZING SYSTEM
1090
LIGHT SOURCE
1020
1025
630
640
1015
1015
1010

Fig. 11

1210
1230
Fig. 12
C
X1 X2 X3 X4 X5 X6 X7 X8 X9 X10 X11 X12
Y1 Y2 Y3 Y4 Y5 Y6 Y7 Y8 Y9 Y10 Y11 Y12
TA
TU

Fig. 13

Fig. 14

1504
1502
$A_s$
$A_i$
1508
1510
1506
1500
MICROPROCESSOR
SURFACE
NORMAL
SPECULARLY
REFLECTED
BEAM

Fig. 15

START
GENERAL INITIALIZATIONS
1600
GENERATE GRID MAP
1610
DETERMINE ETCHING RESULTS
1620
ALL GRID BLOCKS MEASURED?
1630
NO
YES
ANALYZE ETCHING RESULT VALUES
1640
COMPUTE ONE OR MORE ETCHING COMPONENT ADAPTATIONS
1680
$T_U$ EXIST?
1650
YES
NO
FURTHER ADAPTATION WARRANTED?
1670
YES
NO
ACHIEVED DESIRED CDS?
1660
YES
NO
END

Fig. 16

900
906
906
906
906
902
904

Fig. 17

910
912
916
916
916
916
914

Fig. 18

940
942
928
920
922
924
926

Fig. 19

942
940
928
928
928
920
950
922
924
926
PHASE

Fig. 20

940
942
950
928
928
928
920
922
924
926
PHASE
952

Fig. 21

Measured TanPsi signal
TanPsi
0.9
0.8
0.7
0.6
0.5
0.4
0.3
0.2
0.1
200
300
400
500
600
700
800
Wavelength (nm)
Measured and Fitted CosDel
CosDel
1
0.8
0.6
0.4
0.2
0
-0.2
-0.4
-0.6
-0.8
-1
200
300
400
500
600
700
800
Wavelength (nm)
Measured

Fig. 22

D2
D3
D4
D1
280
270
260
240
D6
D7
250
230
D5
220

Fig. 23

18
16
14
13
12
10
19
18
16
14
13
12
10

Prior Art Fig. 24

Prior Art Fig. 25

24
22
20
16
14
13
12
10
10
24
22
20
16
14
13
12
10

Prior Art Fig. 26

Prior Art Fig. 27

26
22
20
16
14
13
12
10
Prior Art Fig. 28
28
30
22
20
16
14
13
12
10
Prior Art Fig. 29

28
22
30
20
16
14
13
12
10

Prior Art Fig. 30

18
16
14
12
10
19
18
16
14
12
10

Fig. 31

Fig. 32

24
22
20
16
14
12
10
24
22
20
16
14
12
10

Fig. 33

Fig. 34

26
22
20
16
14
12
10

Fig. 35

28
30
22
20
16
14
12
10

Fig. 36

28
22
30
20
16
14
12
10

Fig. 37

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 0123871 A
- US 4948259 A